# EUROPEAN PATENT APPLICATION

(11) **EP 4 848 328 A1**
(43) Date of publication of application: **02.12.2026**
(21) Application number: 25186468.2
(22) Date of filing: 30.06.2025
(51) Int. Cl.: H01J 37/02, H01J 37/22

(54) **DISTORTION CORRECTION SCHEME FOR METROLOGY**

(71) Applicant: ASML Netherlands B.V., 5500 AH Veldhoven (NL)
(72) Inventor: HESP, Niels, Caspar, Herman, 5500 AH Veldhoven (NL); KIERS, Antoine, Gaston, Marie, 5500 AH Veldhoven (NL); VILOKKI, Antti Juhani, 5500 AH Veldhoven (NL)
(74) Representative: ASML Netherlands B.V.

(57) **Abstract**

A method is provided for reducing distortion in images acquired from a charged-particle beam apparatus. A plurality of images is acquired over an acquisition period of a fixed field of view, the images comprising features disposed on a substrate. Position data is generated for each image, and first positional information of the features is extracted from the position data. Temporal variations in the first positional information are determined over the acquisition period. The temporal variations are extrapolated toward a reference time to generate second positional information that represents undistorted feature locations. Image distortion is determined by comparing the first positional information to the second positional information. An update is then applied to the plurality of images based on the determined image distortion, enabling correction of drift or charging effects and improving spatial fidelity in charged-particle beam imaging.

## Description

### FIELD

The description herein relates to inspection systems, and more particularly, to methods for reducing image distortion in images generated by a charged particle beam apparatus.

### BACKGROUND

In manufacturing processes of integrated circuits (ICs), unfinished or finished circuit components are inspected to ensure that they are manufactured according to design and are free of defects. Inspection can be performed using systems such as optical microscopes or charged particle beam microscopes (e.g., a scanning electron microscope (SEM)). As the sizes of IC components continue to shrink, accuracy and speed of defect detection become necessary for higher yield and throughput. However, imaging resolution and throughput of inspection tools struggle to keep pace with the ever-decreasing feature size of IC components.

### SUMMARY

Embodiments of the present disclosure provide methods of reducing distortion in images acquired from a charged-particle beam apparatus. In one embodiment, the method comprises acquiring, with the charged-particle beam apparatus, a plurality of images over an acquisition period of a fixed field of view, processing the plurality of images to generate a corresponding set of position data for each image, and extracting first positional information of features from the position data for each image. Temporal variations in the first positional information are determined over the acquisition period and extrapolated toward a reference time to generate second positional information. Image distortion is determined based on a comparison between the first positional information and the second positional information, and an update is applied to the plurality of images based on the determined image distortion.

In some embodiments, a method of determining a systematic distortion fingerprint of a charged-particle beam apparatus is provided. The method comprises acquiring, with the charged-particle beam apparatus, a plurality of images over an acquisition time from distinct locations on a substrate, wherein each location comprises features having a same nominal design. The method further comprises processing the plurality of images to generate position data corresponding to the features and averaging the processed position data from multiple locations to provide a systematic distortion fingerprint.

In some embodiments, a method is provided for reducing distortion in images of periodic features aligned along a grating direction. The method comprises acquiring a plurality of images, generating position data corresponding to edge positions of the periodic features, applying a spatial relationship to determine distortion data comprising displacement vectors representing frame-to-frame displacements along the grating direction, and applying an update to the plurality of images based on the determined distortion data.

In some embodiments, groups of pixels are defined within each image, and spatial relationships between corresponding groups of pixels across the plurality of images are used to determine distortion data. First positional information is extracted from the distortion data, and temporal variations are extrapolated toward a reference time to generate second positional information. A comparison between the first and second positional information is used to determine image distortion, and an update is applied to the plurality of images accordingly.

In some embodiments, a method is provided for determining a key performance indicator (KPI) of a charged-particle beam apparatus. The method comprises acquiring a plurality of images of features disposed on a substrate, applying an image distortion correction to update the plurality of images, processing the updated images to extract positional information and generate position data, determining a feature data profile from the position data, and deriving a statistical metric from the feature data profile as an indicator of operational performance.

### BRIEF DESCRIPTION OF FIGURES

The above and other aspects of the present disclosure will become more apparent from the description of example embodiments, taken in conjunction with the accompanying drawings.
**FIG. 1** is a schematic diagram illustrating an example charged-particle beam inspection system, consistent with embodiments of the present disclosure.
**FIG. 2A** is a schematic diagram illustrating an example single beam inspection apparatus, consistent with embodiments of the present disclosure that can be a part of the example charged-particle beam inspection system of **FIG. 1****.**
**FIG. 2B** is a schematic diagram illustrating an example multi-beam inspection apparatus, consistent with embodiments of the present disclosure that can be a part of the example charged-particle beam inspection system of **FIG. 1****.**
**FIG. 3A** is a schematic diagram illustrates a schematic diagram of an example image distortion occurring in a charged particle beam apparatus.
**FIG. 3B** is a schematic diagram illustrating an example grid.
**FIG. 4** is a schematic flowchart illustrating an example method for dynamic distortion correction, consistent with embodiments of the present disclosure.
**FIG. 5** is a schematic flowchart illustrating an example method for dynamic distortion correction, consistent with embodiments of the present disclosure.
**FIG. 6** is a schematic flowchart illustrating an example method for dynamic distortion correction utilizing spatial cross-correlation, consistent with embodiments of the present disclosure.
**FIG. 7A** is a schematic flowchart illustrating an example method of image distortion correction for removing systematic distortion fingerprints, consistent with embodiments of the present disclosure.
**FIG. 7B** is an example schematic implementation of the method described in **FIG. 7A****,** consistent with embodiments of the present disclosure.
**FIG. 8** is a schematic flowchart illustrating an example method for detecting and correcting dynamic distortions of images comprising grating lines, consistent with embodiments of the present disclosure.
**FIG. 9** is a schematic flowchart illustrating an example method for determining key performance indicators of a charged particle beam apparatus, consistent with embodiments of the present disclosure.

### DETAILED DESCRIPTION

Reference will now be made in detail to example embodiments, examples of which are illustrated in the drawings. The following description refers to the accompanying drawings in which the same numbers in different drawings represent the same or similar elements unless otherwise represented. The implementations set forth in the following description of example embodiments do not represent all implementations consistent with the disclosure. Instead, they are merely examples of apparatuses, systems, and methods consistent with aspects related to subject matter that may be recited in the appended claims. For example, although some embodiments are described in the context of utilizing charged-particle beams (e.g., electron beams), the disclosure is not so limited. Unless infeasible, embodiments described herein can be implemented in any other type of charged particle device (e.g., proton beams). Furthermore, other imaging systems may be used, such as optical imaging, photodetection, x-ray detection, or the like.

Modern electronic devices are constructed of circuits formed on a piece of semiconductor material called a substrate. The semiconductor material may include, for example, silicon, gallium arsenide, indium phosphide, silicon germanium, or the like. Many circuits may be formed together on the same piece of silicon and are called integrated circuits or ICs. The size of these circuits has decreased dramatically so that many more of them can be fit on the substrate. For example, an IC chip in a smartphone can be as small as a thumbnail and yet may include over 2 billion transistors, the size of each transistor being less than 1/1000th the size of a human hair.

Making these ICs with extremely small structures or components is a complex, time-consuming, and expensive process, often involving hundreds of individual steps. Errors in even one step have the potential to result in defects in the finished IC, rendering it useless. Thus, one goal of the manufacturing process is to avoid such defects to maximize the number of functional ICs made in the process; that is, to improve the overall yield of the process.

One component of improving yield is monitoring the chip-making process to ensure that it produces a sufficient number of functional integrated circuits. One way to monitor the process is to inspect the chip circuit structures at various stages of their formation. Inspection can be carried out using a scanning charged-particle microscope (SCPM). For example, an SCPM may be a scanning electron microscope (SEM). An SCPM can be used to image these extremely small structures, in effect, taking a "picture" of the structures of the wafer. The image can be used to determine if the structure was formed properly in the proper location. If the structure is defective, then the process can be adjusted, so the defect is less likely to recur.

The working principle of an SCPM (e.g., an SEM) is similar to a camera. A camera takes a picture by receiving and recording intensity of light reflected or emitted from people or objects. An SCPM takes a "picture" by receiving and recording energies or quantities of charged particles (e.g., electrons) reflected or emitted from the structures of the wafer. Typically, the structures are made on a substrate (e.g., a silicon substrate) that is placed on a platform, referred to as a stage, for imaging. Before taking such a "picture," a charged-particle beam may be projected onto the structures, and when the charged particles are reflected or emitted ("exiting") from the structures (e.g., from the wafer surface, from the structures underneath the wafer surface, or both), a detector of the SCPM may receive and record the energies or quantities of those charged particles to generate an image that may be used for inspection or metrology. To take such a "picture," the charged-particle beam may scan through the wafer ("picture" to generate the inspection image, while some SCPMs use multiple charged-particle beams (referred to as a "multi-beam SCPM," such as a multi-beam SEM) to take multiple "sub-pictures" of the wafer in parallel and stitch them together to generate the inspection image. By using multiple charged-particle beams, the SCPM may provide more charged-particle beams onto the structures for obtaining these multiple "sub-pictures," resulting in more charged particles exiting from the structures. Accordingly, the detector may receive more exiting charged particles simultaneously and generate inspection images of the structures of the wafer with higher efficiency and faster speed.

Generating and processing these images to determine whether any defects exist (sometimes as small as the nanometer scale) are computationally intensive. And as the physical sizes of IC components continue to shrink, accuracy and yield in defect detection become more important. To inspect a single wafer, it is common for an inspection system to generate and process a substantial number of images. For example, if each image taken corresponds to 12 µm × 12 µm portion of a wafer, for a 200mm wafer, it may take over 218 million images to image the entire wafer. If these images are not processed and evaluated efficiently, yield may be dramatically impacted, thereby affecting the wafer throughput.

As the physical sizes of IC components continue to shrink, accuracy and yield in defect detection become more important. Metrology tools can be used to determine whether the ICs are correctly manufactured by identifying a number of defects on each wafer, including at different levels of detail, such as a pattern level, an image (field of view) level, a die level, a care area level, or a wafer level.

Inspection tools such as SEMs are used throughout the fabrication process to monitor feature fidelity, alignment, and defectivity. These tools operate by scanning a focused electron beam across a sample and detecting secondary or backscattered electrons to form high-resolution images of the wafer surface. However, charged-particle imaging is subject to various sources of image distortion-including beam drift, stage instability, scan nonlinearities, and charging effects, which can degrade the spatial accuracy of measured features. Using electrons to obtain an image (e.g., a charged-particle beam image) can present challenges, such as charge buildup in the structures being measured. Charge accumulation on the measured sample may lead to degradation of the produced images and are known to introduce diverse types of artifacts at multiple length scales, such as the aforementioned image distortion, uneven brightness, and image blurring. Image distortion can manifest as spatial displacement of features, blur, or local warping, and can affect metrology applications such as CD measurement, line-edge roughness (LER) analysis, and alignment mark registration. As metrology standards require sub-nanometer precision, distortion correction becomes a necessary step in post-acquisition processing.

SEM inspection systems are also constrained by throughput requirements. A minimum number of electrons per pixel may be required for a high-resolution image. This can either be achieved by scanning slowly a single frame or by quickly scanning multiple frames and averaging them. The former approach, which utilizes long dwell time and slow scanning, may yield higher signal-to-noise (SNR) per frame but may result in significant charged-induced image distortion due to charge buildup on the imaged sample or substrate. The latter approach may utilize fast scanning and multi-frame averaging, reducing charging-induced distortion by lowering the dose per frame. However, this may introduce blurring due to inter-frame distortion difference. Some additional factors that may influence distortion include the sample stack (e.g., feature height, material composition) and the landing energy of the electron beam. As a result, advanced image processing pipelines are used to reconstruct high-fidelity, distortion-corrected representations from multiple low-SNR frames.

The present disclosure provides methods for reducing image distortion using a plurality of images acquired at a fixed location over time. Techniques include determining distortion maps based on dynamic feature tracking, contouring, or cross-correlation. Displacement vectors may be used to compute and correct both dynamic and systematic distortions across the field of view (FOV).

In some embodiments, a distortion correction process involves acquiring a plurality of images, extracting position maps using a contouring algorithm, determining dynamic positions of features across frames, and extrapolating to a distortion-free reference time point (e.g., t=0). Distortion maps comprising spatial displacement vectors may be generated by comparing each frame to an undistorted reference and used to perform pixel-wise corrections via backward mapping and interpolation.

In some embodiments, the present disclosure addresses low signal-to-noise (SNR) imaging scenarios by averaging pixel groups into line traces, extracting global intensity profiles, and applying contour-based or cross-correlation approaches to identify displacement vectors.

Systematic distortion fingerprints may also be determined by comparing SEM images acquired from different wafer locations that share a nominal design. Residuals from parametric alignment models may be averaged across sites to reveal persistent, tool-induced distortions that can be compensated at the wafer or tool level.

In addition to image correction, some embodiments focus on extracting key performance indicators (KPIs) from corrected images or position maps. These KPIs, such as standard deviation of edge placement or power spectral density (PSD), provide insight into low-frequency spatial variability (e.g., intramark error) and can inform process optimization, tool matching, or alignment mark design.

Through these embodiments, the present disclosure enhances the accuracy of SEM-based metrology, reduces distortion-induced error, and enables high-throughput inspection workflows compatible with advanced semiconductor manufacturing.

Objects and advantages of the disclosure can be realized by the elements and combinations as set forth in embodiments described herein. However, embodiments of the present disclosure are not necessarily required to achieve such example objects or advantages. Some embodiments can achieve a different feature or enhancement without necessarily achieving any expressly stated object or advantage.

As used herein, unless specifically stated otherwise, the term "or" encompasses all possible combinations, except where infeasible. For example, if it is stated that a component can comprise A or B, then, unless specifically stated otherwise or infeasible, the component can comprise A, or B, or A and B. As a second example, if it is stated that a component can comprise A, B, or C, then, unless specifically stated otherwise or infeasible, the component can comprise A, or B, or C, or A and B, or A or B and C, or A and B and C.

Relative dimensions of components in drawings may be exaggerated for clarity. Within the following description of drawings, the same or like reference numbers refer to the same or like components or entities, and only the differences with respect to the individual embodiments are described.

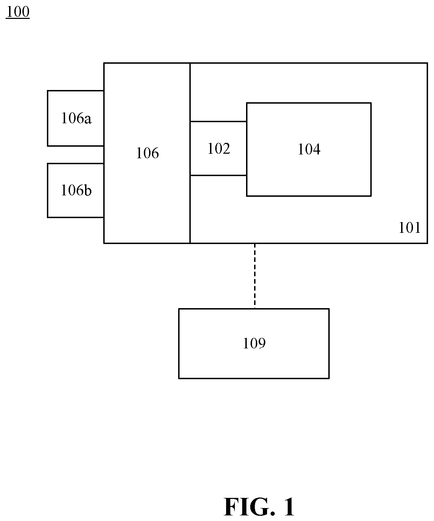

**FIG. 1** illustrates a schematic diagram of an example electron beam inspection (EBI) system 100, consistent with embodiments of the present disclosure. EBI system 100 can be used for imaging. EBI system 100 can comprise a main chamber 101, a load/lock chamber 102, a beam tool 104, and an equipment front end module (EFEM) 106. Beam tool 104 can be located within main chamber 101. EFEM 106 can comprise a first loading port 106a and a second loading port 106b. EFEM 106 can comprise additional loading port(s). First loading port 106a and second loading port 106b can receive wafer front opening unified pods (FOUPs) that contain wafers (e.g., semiconductor wafers or wafers made of other material(s)) or samples to be inspected (wafers and samples may be used interchangeably). The term "lot" can refer to a plurality of wafers that can be loaded for processing as a batch.

One or more robotic arms (not shown) in EFEM 106 can transport the wafers to load/lock chamber 102. Load/lock chamber 102 can be connected to a load/lock vacuum pump system (not shown) that can evacuate gas molecules in load/lock chamber 102 to reach a first pressure below atmospheric pressure. After reaching the first pressure, one or more robotic arms (not shown) can transport the wafer from load/lock chamber 102 to main chamber 101. Main chamber 101 can be connected to a main chamber vacuum pump system (not shown) that can evacuate gas molecules in main chamber 101 to reach a second pressure below the first pressure. After reaching the second pressure, the wafer can be subject to inspection by beam tool 104. Beam tool 104 can be a single-beam system or a multibeam system.

A controller 109 can be electronically connected to beam tool 104. Controller 109 can be a computer configured to execute various controls of EBI system 100. While controller 109 is shown in **FIG. 1** as being outside of the structure that includes main chamber 101, load/lock chamber 102, and EFEM 106, in some embodiments, controller 109 can be part of the structure.

In some embodiments, controller 109 comprises one or more processors (not shown). A processor may be a generic or specific electronic device capable of manipulating or processing information. For example, the processor can comprise a central processing unit (or "CPU"), a graphics processing unit (or "GPU"), an optical processor, a programmable logic controllers, a microcontroller, a microprocessor, a digital signal processor, an intellectual property (IP) core, a Programmable Logic Array (PLA), a Programmable Array Logic (PAL), a Generic Array Logic (GAL), a Complex Programmable Logic Device (CPLD), a Field-Programmable Gate Array (FPGA), a System On Chip (SoC), an Application-Specific Integrated Circuit (ASIC), any type circuitry capable of data processing, or any combination of any number thereof. The processor can be a virtual processor. The virtual processor can include one or more processors distributed across multiple machines or devices coupled via a network.

In some embodiments, controller 109 further comprises one or more memories (not shown). A memory can be a generic or specific electronic device capable of storing instructions, code, or data accessible by the processor (e.g., via a bus). For example, the memory can comprise a random-access memory (RAM), a read-only memory (ROM), an optical disc, a magnetic disk, a hard drive, a solid-state drive, a flash drive, a security digital (SD) card, a memory stick, a compact flash (CF) card, any type of storage device, or any combination of any number thereof. The instructions, code, or data can include an operating system (OS) and one or more application programs (or "apps") for specific tasks. The memory can be a virtual memory. The virtual memory can include one or more memories distributed across multiple machines or devices coupled via a network.

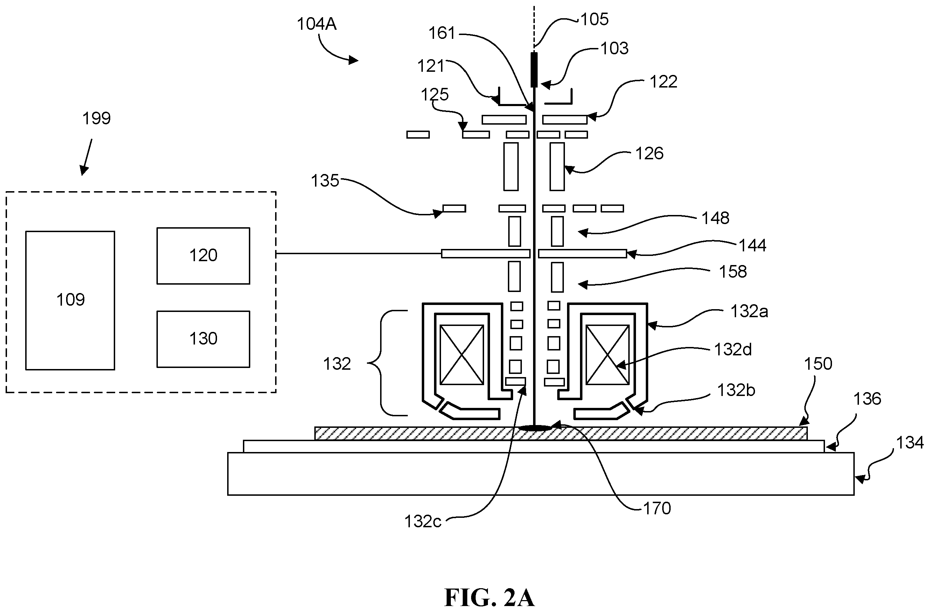

**FIG. 2A** illustrates a schematic diagram of an example beam tool 104A and an image processing system 199 that can be configured for use with EBI system 100 **(****FIG. 1****),** consistent with embodiments of the present disclosure. Beam tool 104A can be provided as beam tool 104 of **FIG. 1****.** In some embodiments, beam tool 104A is a single-beam tool that uses one primary electron beam to scan locations on a wafer in series (one location after the other).

Beam tool 104A can comprise a wafer holder 136 supported by motorized stage 134 to hold a wafer 150 to be inspected. Beam tool 104A can also comprise an electron emitter comprising several elements, such as a cathode 103, an anode 121, and a gun aperture 122. Beam tool 104A can also comprise a beam limit aperture 125, a condenser lens 126, a column aperture 135, an objective lens assembly 132, and a detector 144. Objective lens assembly 132 can be a swing objective retarding immersion lens (SORIL) or a modified version thereof. Objective lens assembly 132 can comprise a pole piece 132a, a control electrode 132b, a deflector unit 132c, and an exciting coil 132d. In a detection or imaging process, an electron beam 161 emanating from the tip of cathode 103 can be accelerated by anode 121 voltage, can pass through gun aperture 122, beam limit aperture 125, condenser lens 126, and can be focused into a probe spot 170 by objective lens assembly 132. Electron beam 161 can impinge onto the surface of wafer 150. A deflector can be used to scan probe spot 170 across the surface of wafer 150 (e.g., deflector unit 132c or other deflector(s) in the SORIL lens). Secondary or scattered particles, such as secondary electrons or scattered primary electrons emanated from the wafer surface can be collected by detector 144 to determine intensity of the beam and so that an image of an area of interest on wafer 150 can be reconstructed.

In some embodiments, image processing system 199 comprises an image acquirer 120, a storage 130, and controller 109. Image acquirer 120 can comprise one or more processors. For example, image acquirer 120 can comprise a computer, server, mainframe host, terminals, personal computer, any kind of mobile computing devices, or the like. Image acquirer 120 can be connected with detector 144 of beam tool 104A through a communication medium, such as an electrical conductor, optical fiber cable, portable storage media, IR, Bluetooth, internet, wireless network, wireless radio, or the like. Image acquirer 120 can receive a signal from detector 144. Image acquirer 120 can construct an image based on the signal from detector 144. Image acquirer 120 can thus acquire images of wafer 150. Image acquirer 120 can also perform various post-processing functions, such as image averaging, generating contours, superimposing indicators on an acquired image, or the like. Image acquirer 120 can perform adjustments of brightness and contrast, etc. of acquired images. Storage 130 can be a storage medium, such as a hard disk, random access memory (RAM), cloud storage, other types of computer readable memory, or the like. Storage 130 can be coupled with image acquirer 120 and can be used for saving scanned raw image data as original images, as well as post-processed images. Image acquirer 120 and storage 130 can be connected to controller 109. In some embodiments, image acquirer 120, storage 130, and controller 109 can be integrated together as one electronic control unit (e.g., on the same chip).

In some embodiments, image acquirer 120 acquires one or more images of a sample based on an imaging signal received from detector 144. An imaging signal can correspond to a scanning operation that is executed for the purposes of charged particle imaging. An acquired image can be a single image comprising a plurality of imaging areas that can contain various features of wafer 150. The single image can be stored in storage 130. Imaging can be performed on the basis of imaging frames.

The condenser and illumination optics of the electron beam tool can comprise, or be supplemented by, electromagnetic quadrupole electron lenses. In the example of **FIG. 2A****,** electron beam tool 104A comprises a first quadrupole lens 148 and a second quadrupole lens 158. The quadrupole lenses can be used for controlling the electron beam. First quadrupole lens 148 can be controlled to adjust the beam current and second quadrupole lens 158 can be controlled to adjust the beam spot size and beam shape.

The single primary beam of beam tool 104A can be used to generate secondary electrons by interacting with wafer 150. Detector 144 can be placed proximally to or aligned with optical axis 105. The primary electron beam can be configured to travel along optical axis 105. Accordingly, detector 144 can comprise a hole at its center so that the primary electron beam can pass through to reach wafer 150. In some embodiments, a detector can be placed off-axis relative to the optical axis along which the primary electron beam travels. In such instances a beam separator can be provided to divert secondary electron beams toward a detector placed off-axis.

The images generated by scanning charged-particle microscopes (e.g., an SEM) can be used for defect inspection. A generated image capturing a test device region of a wafer can be compared with a reference image of the same test device region. The reference image can be predetermined (e.g., by simulation) and include no known defect. If a difference between the generated image and the reference image exceeds a tolerance level, a potential defect can be identified. For another example, an SEM is used to scan multiple regions of a wafer, each region including a test device region designed to be constant from region to region. The SEM can generate multiple images capturing those test device regions as fabricated. These multiple images can be compared with each other. If a difference between the multiple images exceeds a tolerance level, a potential defect can be identified.

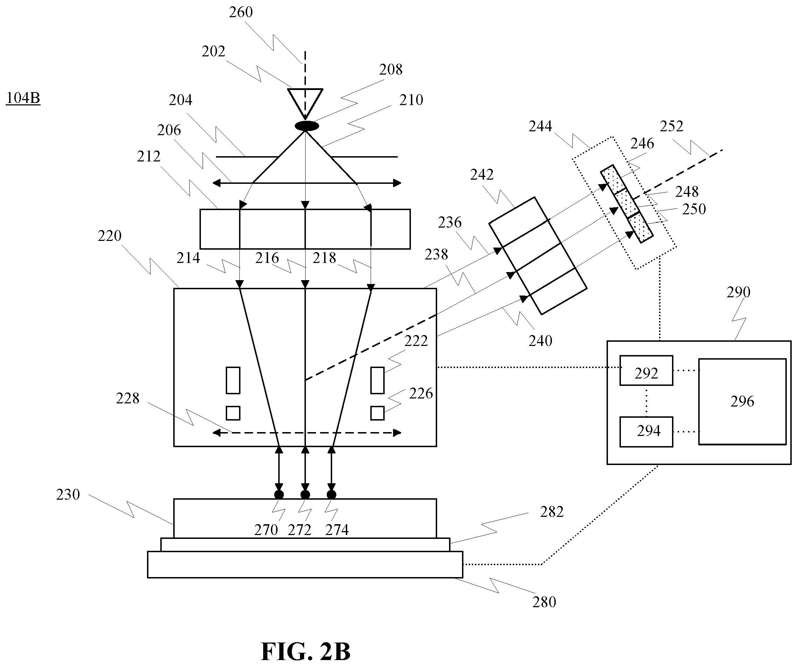

Another example of a charged particle beam apparatus will now be described with reference to **FIG. 2B****,** which illustrates a schematic diagram of an example beam tool 104B and an image processing system 290 that can be configured for use in EBI system 100 **(****FIG. 1****),** consistent with embodiments of the present disclosure. Beam tool 104B can be provided as beam tool 104 of **FIG. 1****.** In some embodiments, beam tool 104B is a multibeam tool that uses multiple beams of primary electrons to scan multiple locations on a wafer. It is appreciated that hardware and functions described in reference to an element in one of **FIGS. 2A** **and** **2B** can be applicable to a corresponding element in the other of **FIGS. 2A** **and** **2B** (e.g., structure and function of a condenser lens, defect analysis of a sample, or the like), unless infeasible.

Beam tool 104B can comprise a charged-particle source 202 configured to emit a primary charged-particle beam 210, a gun aperture 204, a condenser lens 206, a source conversion unit 212, a primary projection optical system 220, a motorized wafer stage 280, a wafer holder 282, a secondary optical system 242, and a charged-particle detection device 244. Primary charged-particle beam 210 can comprise a plurality of beamlets 214, 216, and 218 of primary charged-particle beam 210. Primary projection optical system 220 can comprise a beam separator 222, a deflection scanning unit 226, and an objective lens 228. Charged-particle detection device 244 can comprise detection sub-regions 246, 248, and 250.

Charged-particle source 202, gun aperture 204, condenser lens 206, source conversion unit 212, beam separator 222, deflection scanning unit 226, and objective lens 228 can be aligned with a primary optical axis 260 of beam tool 104B. Secondary optical system 242 and charged-particle detection device 244 can be aligned with a secondary optical axis 252 of beam tool 104B.

Charged-particle source 202 can emit one or more charged particles, such as electrons, protons, ions, muons, or other particle carrying electric charges. In some embodiments, charged-particle source 202 can be an electron source. For example, charged-particle source 202 can comprise a cathode, an extractor, or an anode. Primary electrons can be emitted from the cathode and extracted or accelerated to form primary charged-particle beam 210 (in this case, a primary electron beam) with a crossover 208 (virtual or real crossover). For simplicity, some embodiments will be described in the context of electrons as the charged particles. However, it is appreciated that any charged particle can be used in any embodiment of this disclosure, not limited to electrons. Primary charged-particle beam 210 can be visualized as being emitted from crossover 208. Gun aperture 204 can block off peripheral charged particles of primary charged-particle beam 210 to reduce Coulomb interactions (or Coulomb effect). The Coulomb effect can cause the size of a probe spot (or beam spot) of an electron beam to increase and blur, thereby reducing resolution.

Source conversion unit 212 can comprise an array of image-forming elements and an array of beam-limit apertures. The array of image-forming elements can comprise an array of micro-deflectors or micro-lenses. The array of image-forming elements can form a plurality of parallel images (virtual or real) of crossover 208 with a plurality of beamlets 214, 216, and 218 of primary charged-particle beam 210. The array of beam-limit apertures can limit the plurality of beamlets 214, 216, and 218. While three beamlets 214, 216, and 218 are shown in **FIG. 2B****,** embodiments of the present disclosure are not so limited. In some embodiments, beam tool 104B can be configured to generate a first number of beamlets. For example, the first number of beamlets can be in a range from 1 to 1000 or from 200-500. The first number of beamlets can be, for example, 400 beamlets.

Condenser lens 206 can focus primary charged-particle beam 210. The electric currents of beamlets 214, 216, and 218 downstream of source conversion unit 212 can be varied by adjusting the focusing power of condenser lens 206 or by changing the radial sizes of the corresponding beam-limit apertures within the array of beam-limit apertures. Condenser lens 206 may be an adjustable condenser lens that may be configured so that the position of its first principal plane is movable. The adjustable condenser lens may be configured to be magnetic, which may result in off-axis beamlets 216 and 218 landing on the beamlet-limit apertures with rotation angles. The rotation angles change with the focusing power and the position of the first principal plane of the adjustable condenser lens. In some embodiments, the adjustable condenser lens may be an adjustable anti-rotation condenser lens, which involves an anti-rotation lens with a movable first principal plane. An example of an adjustable condenser lens is further described in U.S. Publication No. 2017/0025241, which is incorporated by reference herein in its entirety.

Objective lens 228 can focus beamlets 214, 216, and 218 onto a wafer 230 for imaging, and can form a plurality of probe spots 270, 272, and 274 on a surface of wafer 230.

Beam separator 222 can be a beam separator of Wien filter type, generating an electrostatic dipole field and a magnetic dipole field. The force exerted by the electrostatic dipole field on a charged particle (e.g., an electron) of beamlets 214, 216, and 218 can be substantially equal in magnitude and opposite in a direction to the force exerted on the charged particle by magnetic dipole field. Beamlets 214, 216, and 218 can, therefore, pass straight through beam separator 222 with zero or minimal deflection angle. However, the total dispersion of beamlets 214, 216, and 218 generated by beam separator 222 can also be non-zero. Beam separator 222 can separate secondary charged-particle beams 236, 238, and 240 from beamlets 214, 216, and 218 and direct secondary charged-particle beams 236, 238, and 240 towards secondary optical system 242.

Deflection scanning unit 226 can deflect beamlets 214, 216, and 218 to scan probe spots 270, 272, and 274 over a surface area of wafer 230. In response to the incidence of beamlets 214, 216, and 218 at probe spots 270, 272, and 274, secondary charged-particle beams 236, 238, and 240 can be emitted from wafer 230. Secondary charged-particle beams 236, 238, and 240 can comprise charged particles (e.g., electrons) with a distribution of energies. For example, secondary charged-particle beams 236, 238, and 240 can be secondary electron beams including secondary electrons (energies ≤ 50 eV) and backscattered electrons (energies between 50 eV and landing energies of beamlets 214, 216, and 218). Secondary optical system 242 can focus secondary charged-particle beams 236, 238, and 240 onto detection sub-regions 246, 248, and 250 of charged-particle detection device 244. Detection sub-regions 246, 248, and 250 can be configured to detect corresponding secondary charged-particle beams 236, 238, and 240 and generate corresponding signals (e.g., voltage, current, or the like) used to reconstruct a scanning charged-particle microscope image (e.g., SEM image) of structures on or underneath the probed surface of wafer 230.

The generated signals can represent intensities of secondary charged-particle beams 236, 238, and 240 and can be provided to image processing system 290 that is in communication with charged-particle detection device 244, primary projection optical system 220, and motorized wafer stage 280. The movement speed of motorized wafer stage 280 can be synchronized and coordinated with the beam deflections controlled by deflection scanning unit 226, such that the movement of the scanning of probe spots (e.g., probe spots 270, 272, and 274) can orderly cover regions of interest on the wafer 230. The movement of the scanning can be, for example, a raster movement. The parameters of such synchronization and coordination can be adjusted to adapt to dissimilar materials of wafer 230. For example, dissimilar materials of wafer 230 can have different resistance-capacitance characteristics that can cause different signal sensitivities to the movement of the scanning of the probe spots.

The intensity of secondary charged-particle beams 236, 238, and 240 can vary according to the external or internal structure of wafer 230 and thus can indicate whether wafer 230 includes defects. Moreover, as discussed above, beamlets 214, 216, and 218 can be projected onto separate locations of the top surface of wafer 230, or different sides of local structures of wafer 230, to generate secondary charged-particle beams 236, 238, and 240 that can have different intensities. Therefore, by mapping the intensity of secondary charged-particle beams 236, 238, and 240 with the areas of wafer 230, image processing system 290 can reconstruct an image that reflects the characteristics of internal or external structures of wafer 230.

Image processing system 290 can include an image acquirer 292, a storage 294, and a controller 296. Image acquirer 292 can comprise one or more processors. For example, image acquirer 292 can comprise a computer, server, mainframe host, terminals, personal computer, any kind of mobile computing devices, or the like, or a combination thereof. Image acquirer 292 can be communicatively coupled to charged-particle detection device 244 of beam tool 104B through a medium such as an electric conductor, optical fiber cable, portable storage media, IR, Bluetooth, internet, wireless network, wireless radio, or a combination thereof. Image acquirer 292 can receive a signal from charged-particle detection device 244. Image acquirer 292 can construct an image (e.g., as a digital representation, an image data file) based on one or more signals from charged-particle detection device 244. Image acquirer 292 can thus acquire scanning charged-particle microscope images of probed regions of wafer 230. Image acquirer 292 can perform various post-processing functions, such as generating contours that are representative of structures in the image, superimposing indicators on an acquired image, or the like. Image acquirer 292 can perform adjustments of brightness and contrast of acquired images.

Storage 294 can be, for example, a storage medium such as a hard disk, flash drive, cloud storage, random access memory (RAM), other types of computer-readable memory, or the like. Storage 294 can be coupled with image acquirer 292. Storage 294 can be used for saving scanned raw image data as original images, as well as post-processed images. Image acquirer 292 and storage 294 can be connected to controller 296. Image acquirer 292, storage 294, and controller 296 can be integrated together as one control unit.

Image acquirer 292 can acquire one or more scanning charged-particle microscope images of a wafer based on one or more imaging signals received from charged-particle detection device 244. An imaging signal can correspond to a scanning operation for conducting charged-particle imaging. An acquired image can be a single image comprising a plurality of imaging areas or an image of an imaging area. The single image can be stored in storage 294. The single image can be an original image that is divided into a plurality of regions. Each of the regions may comprise one imaging area containing a feature of wafer 230. The acquired images can comprise multiple images of a single imaging area of wafer 230 sampled multiple times over a time sequence. The multiple images can be stored in storage 294. In some embodiments, image processing system 290 performs image processing steps with the multiple images of the same location of wafer 230.

In some embodiments, image processing system 290 comprises measurement circuits (e.g., analog-to-digital converters) to obtain a distribution of the detected secondary charged particles (e.g., secondary electrons). The charged-particle distribution data collected during a detection time window, in combination with corresponding scan path data of beamlets 214, 216, and 218 incident on the wafer surface, can be used to reconstruct images of the wafer structures under inspection. The reconstructed images can be used to reveal various features of the internal or external structures of wafer 230 and thereby can be used to reveal defects in the wafer.

When electrons of primary charged-particle beam 210 are projected onto the surface of wafer 230 (e.g., probe spots 270, 272, and 274), the electrons of primary charged-particle beam 210 can penetrate the surface of wafer 230 for a certain depth to interact with deeper matter in wafer 230. Some electrons of primary charged-particle beam 210 can elastically interact with (e.g., in the form of elastic scattering or collision) the materials of wafer 230. Electrons can be reflected or recoiled out of the surface of wafer 230. An elastic interaction conserves the total kinetic energies of the bodies (e.g., electrons of primary charged-particle beam 210) of the interaction, in which the kinetic energy of the interacting bodies does not convert to other forms of energy (e.g., heat, electromagnetic energy, or the like). Such reflected electrons generated from elastic interaction may be referred to as backscattered electrons (BSEs).

Some electrons of primary charged-particle beam 210 can inelastically interact with (e.g., in the form of inelastic scattering or collision) the materials of wafer 230. An inelastic interaction does not conserve the total kinetic energies of the bodies of the interaction, in which some or all of the kinetic energy of the interacting bodies convert to other forms of energy. For example, through the inelastic interaction, the kinetic energy of some electrons of primary charged-particle beam 210 can cause electron excitation and transition of atoms of the materials. Such inelastic interaction can also generate electrons that exit the surface of wafer 230, which may be referred to as secondary electrons (SEs). Yield or emission rates of BSEs and SEs can depend on, e.g., the material under inspection and the landing energy of the electrons of primary charged-particle beam 210 landing on the surface of the material, among others. The energy of the electrons of primary charged-particle beam 210 can be imparted in part by its acceleration voltage (e.g., the acceleration voltage between the anode and cathode of charged-particle source 202 in **FIG. 2B****).** The quantity of BSEs and SEs can be more or fewer (or even the same) than the injected electrons of primary charged-particle beam 210.

An image can be in the form of an analog signal (e.g., detector signals from an SEM). Alternatively, or additionally, an image can have a digital form, which can be stored as a digital file, reside in volatile memory, be transmitted as a digital signal, or the like. When describing image analysis, image manipulation, and other image processes, it is to be appreciated that such processes can be executed on any form or representation of the image. For example, cropping an image can correspond to truncating the corresponding pixels in a digital image file.

The images generated by SEM can be used for defect inspection. For example, a generated image of a test device region of a wafer can be compared with a reference image that corresponds to the same test device region. The reference image can be predetermined (e.g., by simulation) and include no known defect. If a difference between the generated image and the reference image exceeds a tolerance level, a potential defect can be identified. For another example, the SEM can scan multiple regions of the wafer, each region including a test device region designed the same and generate multiple images capturing those test device regions as manufactured. The multiple images can be compared with each other. If a difference between the multiple images exceeds a tolerance level, a potential defect can be identified.

The SEM images can be used to study CD (critical dimension) metrology. CD metrology may measure the accuracy of feature size for fabricated semiconductor devices. For example, physical dimensions of integrated circuits may be measured including linewidth and depth. Feature size and quality may be inspected to determine quality and performance of fabricated devices. CD metrology may also be used in determining the accuracy and printing of photomasks used during the fabrication process to ensure accurate pattern reproduction. In another example, CD metrology may be used for monitoring and controlling the accuracy of a fabrication process to ensure accuracy and consistency.

The images generated can be used for line-edge roughness metrology. Line-edge roughness metrology may be used to characterize and measure the randomness of variation of features printed during the lithography process. In an example line-edge roughness may be used to measure the variation of a line in an integrated circuit printed through lithography. Line variation may be a predictor of device performance and yield metric.

In some embodiments, the SEM images generated may be used for overlay metrology. Overlay metrology may be used to measure the accuracy of alignment between successive layers of a semiconductor device produced through lithography. If layers of a device are not accurately aligned, fabricated devices may short out.

In some embodiments, charged particle implementations described herein can be modified to use photons instead, for example, such as light in the visible, UV, DUV, EUV, x-ray, or any other wavelength range. For example, in a photon embodiment, a secondary beam spot can refer to reflected, refracted, diffracted, or scattered light from a sample upon which a primary light beam is incident. Therefore, while detectors in the present disclosure may be described in the context of electron detection (e.g., SEM), embodiments of the present disclosure can be implemented with other charged particles (e.g., ions) or photons.

Defect inspection, CD metrology, line-edge roughness, and overlay metrology through extracts information from SEM images on small length scales (e.g., < 1 micron). In generated SEM images, it may be observed that dominant distortions may act on scales of 1+ micron.

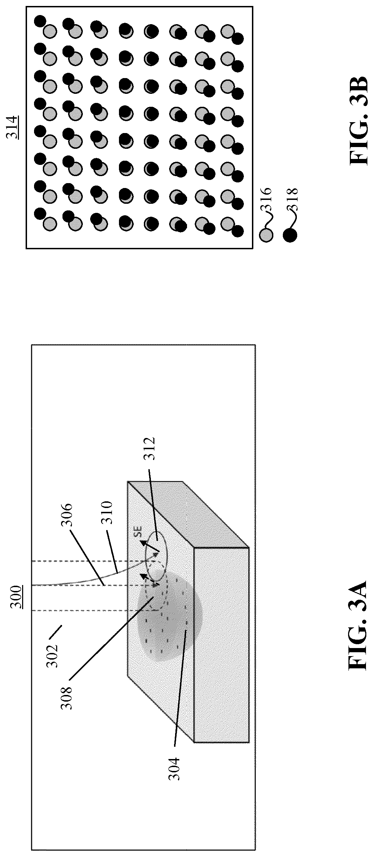

**FIG. 3A** illustrates a schematic diagram of an example image distortion 300 occurring in a charged particle beam apparatus, for example an SEM. An electron beam 302 can be incident on a charged surface 304, resulting in image distortions.

The trajectory 306 represents the expected path of electron beam 302 as it travels toward charged surface 304 under ideal conditions. In such conditions, the electron beam 302 is anticipated to land within area 308, which corresponds to the expected landing zone on the charged surface 304. However, the interaction between the electron beam 302 and the charged surface 304 can introduce complexities that lead to deviations from the expected behavior. These deviations may manifest as distortions in the scanning electron microscope (SEM) image, which can significantly impact the accuracy and reliability of the imaging process. Distortion effects may arise from a variety of factors, including localized charge buildup on surface 304, electromagnetic interference, or imperfections in the SEM's electron optics system.

One consequence of such distortions is the drift of the electron beam 302 away from its intended trajectory 306, resulting in an altered trajectory 310. This drift can occur due to changes in the electric or magnetic fields near the charged surface 304, which deflect the electron beam from its original path. Consequently, the electron beam 302 no longer lands within the expected area 308 but instead impacts the charged surface 304 at a different location, represented as area 312. This shift in landing area can lead to inaccuracies in the SEM image, such as blurring, misalignment, or artifacts, which may obscure critical details of the surface being analyzed.

**FIG. 3B** illustrates an example schematic grid 314. Grid 314 may be a field of view (FOV) of an SEM image of contact holes disposed on a charged surface, for example charged surface 304 in **FIG. 3A****.**

Grid 314 may be comprised of a FOV of contact holes disposed on a charged surface. The charged surface may be part of a semiconductor wafer or a photomask used in lithographic processes. The contact holes can be arranged in a regular pattern, such as a rectangular or hexagonal grid, to facilitate electrical connections or optical alignment.

Holes 316 can represent contact holes in an undistorted image (e.g., when no image distortion is present in the image). In this scenario, the contact holes maintain their intended geometric arrangement, such as consistent spacing and alignment. The undistorted image may be captured using high-resolution imaging systems, such as scanning electron microscopes (SEM) or optical inspection tools, to verify the integrity of the pattern. The absence of distortion ensures that the contact holes align correctly with subsequent layers or components in the manufacturing process.

Holes 318 can represent the distorted grid of contact holes when image distortion is present in the image. The distortion may manifest as irregular spacing, skewed alignment, or changes in the shape of the contact holes. Such distortions can arise from imperfections in the imaging system, variations in the manufacturing process, or environmental factors such as thermal expansion. Advanced image processing algorithms may be employed to detect and quantify these distortions, enabling corrective measures to be implemented.

The distortions may be, for example, due to magnification and rotation distortions. Magnification distortion can cause the contact holes to appear larger or smaller than their actual size, while rotation distortion can result in angular misalignment of the grid. Magnification distortions may also cause the pitch between contact hole arrays to appear distorted from their actual pitch, particularly over large distances. These distortions may be modeled mathematically using transformation matrices or polynomial equations to understand their impact on the overall pattern. Compensation techniques, such as adaptive optics or software-based corrections, may be applied to mitigate the effects of magnification and rotation distortions.

Holes 318 may represent a grid with magnification and rotation distortion in a spatial direction. The spatial direction may refer to the X-Y plane of the charged surface, where the distortions affect the relative positions of the contact holes.

Image distortion may be a result of sources including residuals of tool calibration (e.g., errors arising in the raster scan) and resultant charging induced component of the electron beam interacting with a charged surface. To correct image distortion, in an example, the image of an FOV may be fitted with a pattern information used for printing the objects in the image. The pattern information may be for example a GDS file, wherein the layout and patterns for a device printed on a wafer may be represented in a binary file format. The SEM image may be fitted with the pattern information and a difference between the image and the pattern information may be calculated. A third order polynomial may be fitted to the difference to describe the image distortion. If the image is homogenous and not too big, the third order polynomial may describe the image distortion within the image. However, on larger length scales (e.g., >1 micron) or in cases when an image has variations in the pattern densities in the features, the third order polynomial may not be accurate for describing the image distortion. The third order polynomial in cases where the pattern densities vary substantially, there may be underfitting or overfitting of the features in the image, leading to artifacts and residuals.

Embodiments of the present disclosure provide a method for correcting image distortions over long length scales. Image distortions over long length scales may be corrected for in images generated by, for example, an SEM system. The method may involve determining dynamic distortions and provide a method for correcting them. Determining and correcting for dynamic distortions may be applicable over longer length scales. The distortion corrected images generated with the method may provide information that may be used over longer length scales for CD metrology, defect inspection, line-edge roughness metrology, overlay metrology, etc.

As used herein, the term "distortion correction" refers to a form of update in which spatial or temporal displacements-typically described by distortion data such as distortion maps-are applied to image data, position data, or extracted features in order to compensate for distortions introduced during acquisition. Distortion correction may include pixel-wise realignment, intensity resampling, or coordinate adjustment to produce more spatially accurate or temporally consistent representations.

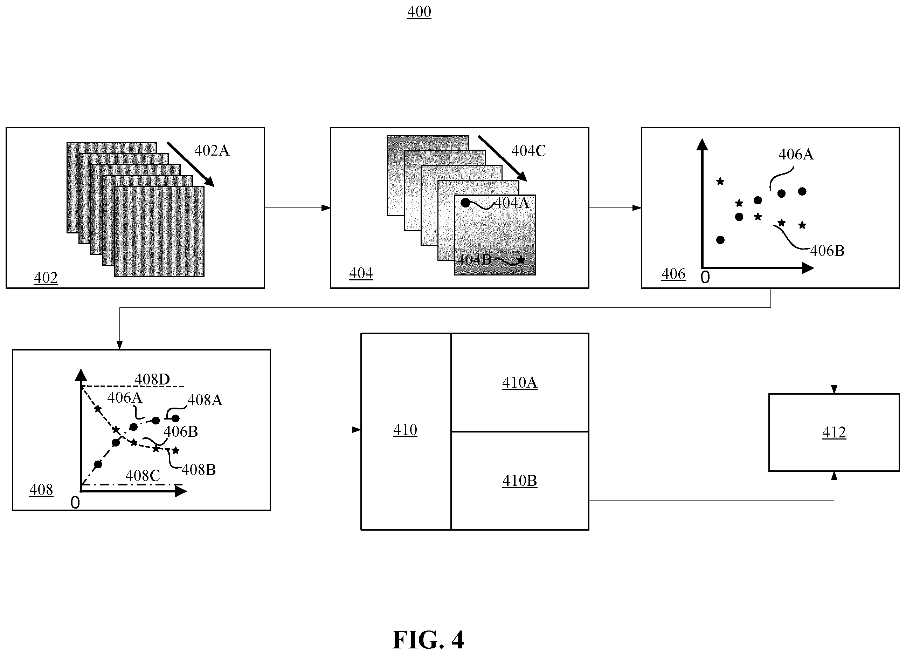

**FIG. 4** illustrates a schematic flowchart 400 of a method for dynamic distortion correction, consistent with embodiments of the present disclosure. Flowchart 400 illustrates a method for determining dynamic distortions and provides a method for correcting them. The method described by flowchart 400 may be used to correct images generated by inspection tool described in reference to **FIG. 1****.** The method described in flowchart 400 may be used to correct images generated in a charged particle beam apparatus, for example the single-beam or multi-beam apparatus of either **FIG. 2A** **or** **FIG. 2B****.**

At operation 402, a plurality of images 402A may be acquired, for example, within a fixed field of view (FOV) encompassing features located on a substrate. The plurality of images 402A may be acquired over an acquisition period by a charged-particle beam apparatus at a same location on a wafer (e.g., the FOV does not change over the period of acquisition times). The acquisition time refers to a specific point at which an image is acquired by the charged-particle beam apparatus. The acquisition period refers to the collective period of time required to acquire the plurality of images 402A. The acquisition period may be short or long. For shorter acquisition periods, each image may have shorter time intervals between acquisition times and may result in noisier images. Longer acquisition periods may result in longer time intervals between acquisition times, yielding better quality images, but may require additional processing time delaying throughput. The time intervals may also be variable across the acquisition period. For example, the first few acquired images may have shorter time intervals between them than the later acquired images in the acquisition period. The time interval between the acquired first and second frame may, for example, be shorter than the time interval between the fifth and sixth acquired images. The plurality of images 402A may be demonstrative and show a plurality of five frames acquired at a same location on a substrate at different acquisition times. However, the method is not limited to five frames, and any frame numbers may be acquired. Frame number refers to the order of the plurality of images 402A. A later frame number may refer to a frame acquired at a later acquisition time in the acquisition period. A plurality of images may be acquired with a frame number of two or nine, for example. The image examples shown in the plurality of images 402A represent lines (e.g., grating lines). The substrate can be a wafer used in a lithographic process, or any other. The features can be, for example, a pattern of contact holes or line gratings produced through lithographic processing.

At operation 404, the plurality of images 402A may be processed to generate position data of the features on the substrate. As used herein, the term "position data" refers to information that describes the spatial location of features within images acquired by a charged-particle beam apparatus. Position data may be derived from position maps, which define the coordinates (e.g., x and y) of extracted features such as edges, contours, or centroids within a field of view. Position data may be generated using image processing techniques such as contouring algorithms, center of gravity (CoG) analysis, or other feature extraction methods.

In an example implementation, a contouring algorithm may be applied to the plurality of images 402A to provide a plurality of position maps 404C (e.g., position data). At operation 404, a position map may be provided for each image in the plurality of image 402A acquired over the acquisition period to provide the plurality of position maps 404C. A contouring algorithm may be a type of computational technique that extracts edges, shapes, or surface topography of features in an image. The contouring algorithm traces intensity contours or boundaries in the greyscale images provided by the charged-particle beam apparatus. The position map is a type of position data that records the pixel coordinates (for example, in position (x,y)) of the defined traces of the contouring algorithm. From the pixel coordinates in the position maps, first positional information may be acquired. As used herein, the term "first positional information" refers to the extracted spatial locations of features identified within images acquired by a charged-particle beam apparatus. In some embodiments, the first positional information is derived from position data and represents the initial measured positions of features prior to any extrapolation or correction. The feature locations can be recorded as pixel locations with the plurality of position maps 404C (e.g., position data) to provide first positional information that may be used for further analysis in other operations of flowchart 400. The positions of, for example, pixel 404A or pixel 404B may be extracted from the plurality of position maps 404C provided by the contouring algorithm. The pixel positions can be provided in the position map as a function (x,y) of the field of view (FOV).

At operation 406, the temporal variations of features may be determined based on the first positional information extracted at operation 404. The extracted positions of each feature (e.g., pixels 404A and 404B) across the acquisition time define a temporal trajectory reflecting positional changes due to image distortion. As used herein, temporal variations refer to changes in the positions of features over time during image acquisition. Temporal variations are derived from the first positional information and may also be referred to as dynamic positions. In an example, dynamic positions of the extracted features in the plurality of position maps 404C may be determined. Across successive position maps, the position of features may drift due to image distortions. To determine the temporal variations (e.g., dynamic positions) of features, the pixels representing the features can be mapped as a function of position and acquisition time. For example, the temporal variations with respect to time (e.g., dynamic positions) of pixel 404A and pixel 404B can be determined from the plurality of position maps 404C. To determine the dynamic position, the position of pixel 404A or 404B may be determined from each position map in the plurality of position maps 404C and plotted as a function of acquisition time (or frame number). Plot 406A demonstrates the temporal variations (e.g., dynamic position) of pixel 404A. Plot 406B demonstrates the dynamic position of pixel 404B.

At operation 408, the temporal variations may be extrapolated towards a reference time to generate second positional information. As used herein, the term "second positional information" refers to feature location data generated by extrapolating the first positional information to a reference time at which image distortion is estimated to be absent or minimized on a substrate. In an example, an undistorted position map (second position information) may be generated by extrapolating the dynamic position (temporal variations) of features to a reference time point, for example t=0 As used herein, an "undistorted position map" may be understood as a form of second positional information representing extrapolated or distortion-free feature locations. The undistorted position map at the reference time point represents a time absent beam interaction on the features or substrate in the acquired plurality of images 402A. To determine the undistorted position map at the reference time point, the plots 406A and 406B of dynamic position may be extrapolated towards t=0, with using a suitable fitting model. While a first-order polynomial model (e.g., y=ax + b) may be insufficient in certain cases, higher-order polynomial models (e.g., second-order polynomials) or non-polynomial models such as exponential functions may be used to better capture non-linear temporal behavior. The fitting may be performed independently for each spatial location. The fitting may also be performed collectively across a group of spatial locations. For the case of the fitting being done collectively, shared model parameters (e.g., a common slope) may be used to reduce the number of degrees of freedom. For example, applying a first-order fit to N points with a shared slope and individual offsets results in only N+1 parameters, compared to 2N if fitted independently. Parameter sharing may improve fit stability, particularly when the number of available time points (e.g., frames) may be limited. Fitting may also be performed across multidimensional spaces such as (time, x, y) using polynomial models with cross-terms, yielding robust extrapolations even in the presence of noisy images.

In an example, plot 406A can be fitted with model 408A and extrapolated towards position 408C. Plot 406B can be fitted with model 408B and extrapolated towards position 408D. Position 408C is the extrapolated position at the reference time point of pixel 404A in the undistorted position map. Position 408D is the extrapolated position at the reference time point of pixel 404B in the undistorted position map. Extrapolation can be done for every pixel in the position map to provide an undistorted position map of the original FOV. Offsets (e.g., difference in positions between neighboring points) in the y-direction between successive points (e.g., acquisition time or frame number) in the x-direction in plot 406A or 406B can be attributed to image distortion. The offsets can be represented with spatial displacement vectors that define the difference between the distorted pixel position on a position map and the pixel position on the undistorted position map. The plotting and modeling shown is exemplary in one-dimension. In some embodiments, the modeling and plotting can be executed in two-dimensions .

At operation 410, image distortions may be quantified and corrected based on a comparison between the first positional information and the second positional data. The image distortion may be determined by comparing feature positions (e.g., first positional information) extracted from the plurality of position maps 404C (e.g., position data) relative to the undistorted position map (e.g., second positional data) as reference to determine distortion data. Each position map is compared to the undistorted position map to determine a distortion map consisting of spatial displacement vectors. These spatial displacement vectors describe the position offset for each pixel between its observed (distorted) and extrapolated (undistorted) position. The comparison may be performed using subtraction or addition operations. The comparing may be performed on a pixel-by-pixel basis across all position maps in the plurality of position maps 404C to yield a plurality of distortion maps (e.g., distortion data) corresponding to the plurality of images 402A or plurality of position maps 404C.

As used herein, the term "distortion data" refers to information that characterizes spatial deviations or displacements present in image data acquired from a charged-particle beam apparatus. Distortion data may include or be derived from distortion maps, wherein a distortion map may comprise displacement vectors that describe positional offsets of image features, pixel regions, or extracted elements (e.g., edges, contours) relative to an expected or undistorted reference. Distortion data may be used to detect, quantify, and correct image distortions such as those caused by beam drift, lens asymmetry, or mechanical instability during image acquisition.

In sub-operation 410A, to correct for the determined image distortion, the distortion correction can be applied to the plurality of position maps 404C (e.g., position data). Each spatial displacement vector determined from the plurality of distortion maps (e.g., distortion data) may be used to realign distorted features toward their undistorted location on a pixel-by-pixel basis. This may be performed for each position map in the plurality of position maps 404C. Distortion corrected position data may be provided as a plurality of distortion corrected position maps. The distortion corrected position data (e.g., plurality of distortion corrected position maps) may then be averaged to produce composite distortion corrected position data. The averaging may be spatial or temporal and typically performed on a pixel-by-pixel basis. As used herein, "distortion corrected position data" refers to position data (e.g., position maps) that has been corrected using displacement vectors derived from distortion data, resulting in pixel-aligned or spatially accurate representations of features. The resulting composite distortion-corrected position data may have reduced noise and mitigated frame-specific artifacts that may be caused by beam drift or scan-rate variations. The comparing may be subtraction or addition of plurality of distortion maps.

In sub-operation 410B, the plurality of distortion maps (e.g., distortion data) may be applied to correct the plurality of images 402A. Each image in the plurality of images 402A may represent intensity as a function of pixel position and may be considered as a two-dimensional pixel grid. For each image, a corresponding distortion map defines a set of spatial displacement vectors that describe the deviation of observed pixel positions from their nominal, undistorted positions. The distortion map may be defined as a coarser spatial grid than the pixel resolution of the image (e.g., derived from a position map such as 404 that contains fewer feature edges than image pixels). Accordingly, interpolation (e.g., bilinear or bicubic) may be used to estimate displacement vectors at arbitrary image pixel positions from the coarser distortion map grid.

To perform distortion correction at sub-operation 410B, the pixel grid of each image in the plurality is aligned to its respective distortion map. Specifically, for each pixel in the target (undistorted) coordinate space, a corresponding source location in the raw (distorted) image is computed by subtracting the interpolated displacement vector defined in the distortion map. This backward mapping ensures that each pixel in the undistorted position map can be assigned an intensity value from the distorted image. The displacement vectors used in this backward mapping may be explicitly defined at grid points within the distortion map; for positions between grid points, bilinear or bicubic interpolation may be applied to determine the displacement at each image pixel. Backward mapping is a form of image distortion correction that reassigns pixel intensities based on interpolated inverse displacement. The intensity at the computed source location is determined via interpolation (e.g., bilinear or bicubic interpolation), thereby generating a corrected image that is spatially aligned to the undistorted coordinate grid. This process is repeated for each image in the plurality of images 402A, producing a corresponding plurality of distortion-corrected images. The distortion-corrected images may then be averaged, on a pixel-by-pixel basis, to generate a composite distortion-corrected image with improved signal-to-noise characteristics

At operation 412, further analysis may be performed based on the outputs of the distortion correction operations. In some embodiments, the composite distortion-corrected position data generated in sub-operation 410A may be utilized for further analysis, such as CD metrology, defect detection, or image alignment. In some embodiments, the composite distortion-corrected image produced in sub-operation 410B may be employed for further analysis. The choice of output for analysis may depend on the specific application or the type of spatial or intensity-based features being evaluated.

Flowchart 400 provides a method for determining dynamic distortions and correcting them. Flowchart 400 describes dynamic distortion determination and correction in one dimension; however, the method is not limited to one-dimension and can be applied in at least two dimensions. The plurality of images 402A acquired can be as a function of acquisition time or frame number. The acquisition time may be determined by variables of the charged-particle apparatus including dwell time of the beam on the sample, scan-speed/rate, image resolution, etc. Two or more frames may be acquired in the plurality of images 402A for processing. However, there may be practical limits on frame acquisition. After a certain number of frames may be acquired, the benefit of acquiring additional frames may diminish, as limited additional information may be gained. As the total acquisition period increases, accumulated charge due to beam dwell time or high electron doses may be possible, however such effects may be mitigated in the context of this disclosure by using shorter acquisition times per frame.

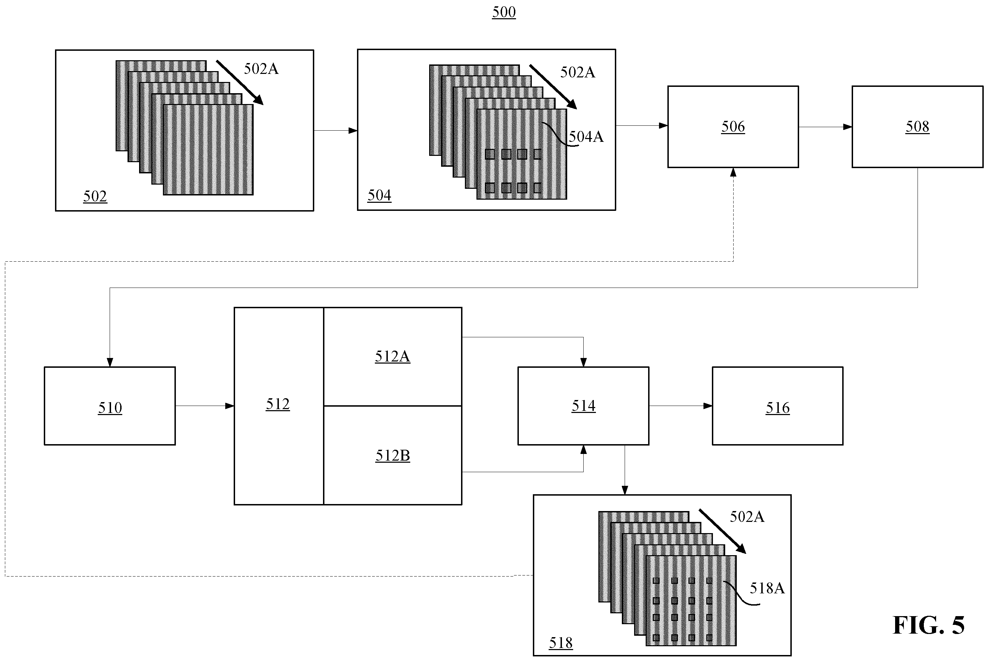

The method as described in flowchart 400 pertains to processing an entire FOV and may require computational resources and processing time. In an example implementation, it may be attractive to reduce computational resources and processing time, for example, to maintain throughput as required of some lithographic processes . It may also ensure that the throughput of a charged-particle beam apparatus, for example an SEM, may be scan-limited and not limited by computational effort. In such a case, another method may be preferred that reduces computational resources and processing time. Some images generated may also be too noisy and a method for using noisy images may be preferred. Reference is now made to **FIG. 5****.**

**FIG. 5** illustrates a schematic flowchart 500 of an example method of dynamic distortion correction, consistent with embodiments of the present disclosure. The method described by flowchart 500 may be used to correct images generated by the inspection tool described in reference to **FIG. 1****.** Flowchart 500 comprises a method that may be utilized for dynamic distortion correction of noisy images generated from an inspection tool, for example a charged particle beam apparatus according to either **FIG. 2A** **or** **FIG. 2B****.** These rapid acquisitions can introduce increased noise and frame-to-frame distortions due to beam or stage instability.

At operation 502, a plurality of images 502A may be acquired over a fixed field of view (FOV) in the same manner as the plurality of images 402A as described in reference to operation 402 of flowchart 400. The images may contain periodic or repeating features (e.g., contact holes or grating lines) disposed on a substrate. The acquisition period of the plurality of images 502A may be short. Due to the short acquisition period, time intervals between acquisition times of each image may also be short. Shorter acquisition time intervals may result in higher noise levels and misalignments of features. Although five frames are shown illustratively, any number of frames (e.g., two or more) may be acquired over the period.

At operation 504, groups of pixels 504A may be defined. Groups of pixels 504A may be defined with, for example, boxes comprising a rectangle or a square profile (profile shape is not necessarily limited and may be other shapes). The groups of pixels 504A may be applied to each image in the plurality of images 502A at the same position in the FOV. Each group of pixels 504A may consist of a rectangular region (e.g., 32 or 64 pixels wide), and one-dimensional line traces may be defined along the box direction (e.g., vertical). These line traces may be averaged within each group to produce a group-averaged line trace. The averaging may be performed for each group to obtain a plurality of group averaged line traces. Each group of pixels may be represented in the plurality by a corresponding group averaged line trace. Each image in the plurality of images 502A may have the corresponding groups of pixels 504A averaged to generate a plurality of group averaged line traces corresponding to the plurality of images 502A, with respect to acquisition time or frame number.

At operation 506, the plurality of group averaged line traces may be processed to generate position data. For example, a contouring algorithm may be applied to the plurality of group averaged line traces to provide a plurality of position maps (e.g., position data). From the position data, first positional information may be extracted (e.g., feature positions may be extracted). The contouring algorithm may be applied to the plurality of group averaged line traces in the same manner as operation 404 as described above in reference to **FIG. 4****.** The contouring algorithm may provide a plurality of position maps describing the extracted positions of features or boundaries in position (x,y). That is, the corresponding pixel positions of the group averaged line traces may be represented in a position map with position (x,y). The contouring algorithm may then be applied to each line trace in the plurality of group averaged line traces to provide a plurality of position maps. As used herein, first positional information refers to the extracted spatial locations of features obtained from processing image data (e.g., via contouring).
As used herein, position data refers to the extracted spatial coordinates of image features, such as those contained in position maps.

At operation 508, temporal variations of the first positional information may be determined by evaluating feature position changes across the acquisition period. These dynamic changes may be interpreted as temporal variations derived from the first positional information. In an example, the dynamic positions (temporal variations) of the extracted features positions (first positional information) may be determined from the plurality of position maps (position data) provided at operation 504. The dynamic positions may be determined in the same manner as operation 506, described above in reference to **FIG. 4****.** To determine the dynamic positions, the extracted pixel positions representing features in the plurality of position maps may be mapped as a function of acquisition time (or frame number). From these variations, distortion data may be generated by computing the relative displacements of features between successive position maps, represented as a plurality of distortion maps. Each distortion map comprises spatial displacement vectors that describe pixel-wise offsets due to dynamic image distortions. As used herein, distortion data refers to information characterizing spatial deviations, including displacement vectors, and may be derived from distortion maps.

At operation 510, a second positional information may be generated by extrapolating temporal variations towards a reference time. For example, an undistorted position map may be generated by extrapolating the dynamic positions towards t=0. In some embodiments, the undistorted position map may be generated in the same manner as the undistorted position map at operation 408, described above in **FIG. 4****.** This may be done by applying any sufficient multi-order polynomial model as described above in reference to **FIG. 4****.** The extrapolation may be done for each pixel position and the corresponding dynamic position to provide an undistorted position map at t=0.

At operation 512, image distortions may be determined and corrected based on a comparison between the first and second positional information. This may follow the same process as described for operation 410 of **FIG. 4****.**

In sub-operation 512A the distortion data (e.g., the displacement vectors from the distortion maps) may be applied to the position data. Each distortion map (e.g., distortion data) provides a set of displacement vectors used to realign distorted features toward their undistorted locations on a pixel-by-pixel basis. This may be performed for each position map in the plurality . A plurality of distortion-corrected position maps (e.g., distortion corrected position data) may be provided. The displacement vectors may be computed through pixel-wise subtraction or addition operations between distorted and reference positions. This correction reduces temporal misalignments and enhances spatial accuracy in the position maps.

At sub-operation 512B, distortion correction may be applied to the plurality of images 502A using the corresponding distortion data. For each image, the distortion map defines a field of displacement vectors that describes the deviation of pixel positions due to distortion effects. These distortion maps are used to perform a backward mapping from the undistorted pixel coordinates to the corresponding source location in the original (distorted) image. Pixel intensities at these source locations are interpolated (e.g., using bilinear or bicubic interpolation), producing a distortion-corrected image spatially aligned to the undistorted coordinate system.

At operation 514, either distortion corrected position data or the plurality of distortion corrected images may be averaged. In some embodiments, subsets of the distortion corrected position data may be averaged separately (e.g., frames 1-4 or frames 5-8. In some embodiments, subsets of the plurality of distortion corrected images may be averaged (e.g., frames 1-4 or frames 5-88). Averaging subsets may provide for enhancement of signal-to-noise ratio and stabilizing spatial alignments. Averaging subsets during intermediate steps may be used to support the iterative process described below. Specifically, analyzing the subsets separately may help evaluate whether spatial misalignment or signal quality varies across the acquisition period. If the iterative process converges or completes, a final average may be taken across all distortion-corrected frames (position data or images) to generate a single output for analysis. In cases where the sampling grid changes between the iterations (e.g., due to adjusting the groups of pixels), different spatial locations may be used in each subset, further motivating evaluation between subsets separately before final averaging.

At operation 516, the subsets of averaged distortion corrected position data or the subsets of the averaged plurality of distortion corrected images may be provided for further analysis.

In some embodiments, the method provided in flowchart 500 may be an iterative process. If fidelity of the plurality of distortion corrected images or the distortion corrected position data is not sufficient for analysis, the method may be iterated. At operation 518 groups of pixels 518A may be applied to the plurality of images 502A. The groups of pixels 518A may be more numerous and smaller in profile than groups of pixels 504A. The iterative process may be repeated at operation 506. In another example, the iterative process may begin with operation 502 and another plurality of images 502A may be acquired. Iteration may be determined by the contrast-to-noise (CNR) ratio of the resulting subsets of averaged plurality of distortion corrected images or distortion corrected position data. CNR is a quantitative measurement of the fidelity of a feature (e.g., line, hole, or particle) describing how the feature stands out against the background relative to the level of image noise.

The initial group size (e.g., box size) may be selected based on an expected or desired signal-to-noise ratio (SNR). Smaller pixel groups may reduce SNR, especially when fewer frames are used. A threshold SNR value may be used to determine an appropriate initial group size. As more frames are averaged, the effective SNR increases, enabling the use of smaller groups in later iterations while maintaining comparable SNR. For example, averaging over N frames may allow for using groups that are approximately one divided by N in area compared to the initial group size.

If an iterative process is not initiated, the subsets may be averaged together to provide a final composite distortion corrected position data or distortion corrected image.

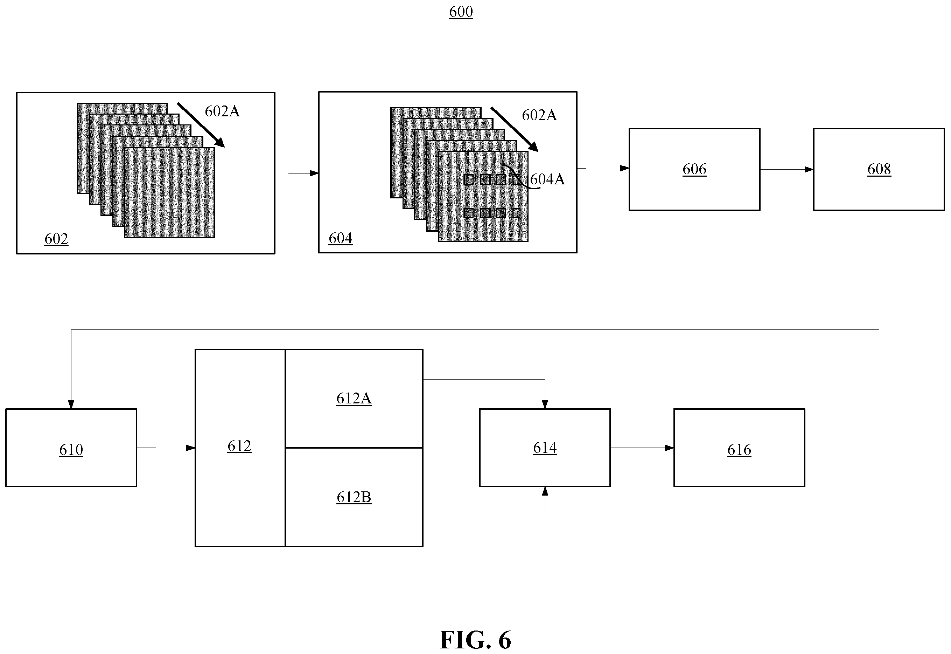

While the method of flowchart 500 leverages averaged line traces and processing to extract placement information from noisy images, other embodiments may apply spatial relationship techniques directly to defined pixel groups to detect local displacements between successive frames. Such an approach enables direct measurement of distortion-induced motion across the field of view without requiring initial conversion to position data. Reference is now made to **FIG. 6****.**

**FIG. 6** illustrates an exemplary flowchart 600 for a method of dynamic distortion correction utilizing spatial relationships, consistent with embodiments of the present disclosure. The method described in flowchart 600 provides a method of image distortion correction for images acquired by a charged particle beam apparatus. The method may utilize spatial relationships between defined groups of pixels across multiple frames.

At operation 602, a plurality of images 602A may be acquired of features disposed on a substrate. The plurality of images 602A may be acquired with a charged particle beam apparatus over a fixed field of view (FOV). The images may be acquired over a short acquisition period to maintain throughput of a lithographic process or to provide metrology results. A shorter acquisition period may provide shorter time intervals between acquisition times. A shorter acquisition period may lead to prominent levels of noise in the plurality of images 602A. Features may be imaged that may include lithographically patterned elements (e.g., contact holes, grating lines). The plurality of images 602A may include any number of frames (e.g., two or more), each acquired at an acquisition time. Higher frame numbers may refer to images acquired at successive acquisition times. Each image comprises a two-dimensional pixel grid. The acquired plurality of images may exhibit frame-to-frame distortion due to beam drift or stage instability.

At operation 604, groups of pixels 604A may be defined within each image of the plurality of images 602A. The groups of pixels 604A may comprise rectangular or square subregions of the image. For each group, a two-dimensional spatial cross-correlation, which may comprise a method for determining spatial relationships between corresponding image regions, may be performed between matching regions across successive images. The cross-correlation yields a spatial displacement vector for each group, describing local positional shifts (e.g., in x and y) of image content between frames. The spatial cross-correlation may be performed in one or two dimensions. Performing cross-correlation across defined groups in the field of view (FOV) provides local displacement vectors. These displacement vectors collectively form a distortion map, which may be understood as distortion data describing spatial displacements of image regions across frames. The distortion data may comprise first positional information, such as extracted or inferred feature positions, enabling downstream determination of distortion behavior.

At operation 606, the temporal variations (e.g., dynamic positions) of features may be determined based on the distortion data (e.g., distortion maps) generated in operation 604. Each distortion map comprises displacement vectors that represent the relative displacement of pixel regions or features at a specific acquisition time. For each pixel region or feature, the corresponding displacement vectors across the plurality of distortion maps define a temporal trajectory that reflects dynamic distortions during the acquisition period. In this context, the dynamic distortions may be considered as temporal variations in feature positions over the acquisition period. A low-order polynomial model (e.g., linear or quadratic) may be fit to this trajectory to characterize and potentially correct the dynamic distortion behavior.

At operation 608, second positional information (e.g., an undistorted image) may be determined based on extrapolation of the temporal variations (e.g., dynamic distortions). As used herein, second positional information refers to extrapolated positions of features at a reference time and may be represented by an undistorted image. Each distortion map represents displacement vectors at a certain acquisition time, corresponding to spatial displacements of features or pixels across the plurality of images 602A. For each pixel region or feature, the time-dependent displacement vectors form a trajectory that may be modeled using a parametric model. Depending on the type of distortion behavior, suitable models may include linear, quadratic, or exponential functions. To avoid overfitting and improve stability, models with fewer degrees of freedom may be preferred. These models may then be extrapolated to a reference time point, typically t = 0, which corresponds to an image absent of dynamic distortion. The extrapolated positions define an undistorted image (e.g., second positional information) that serves as a spatial reference for correcting the distortions in the original image plurality .

At operation 610, image distortion may be corrected by aligning each image in the plurality of images 602A to the second positional information (e.g., undistorted image) determined in operation 608. For each image, the corresponding distortion map at that acquisition time (e.g., distortion data) provides spatial displacement vectors indicating how pixel positions deviate over time. The displacement vectors may be determined using cross-correlation between small crops extracted from pairs of frames. For example, a small region (crop) from frame 1 may be compared to a crop of the same size from frame 2, initially extracted from the same (x, y) location. If there is no distortion difference between the frames, the cross-correlation will be relatively high. By shifting the crop in frame 2 over a small region around its original location and computing the correlation at each offset, the location of maximum correlation can be identified. The displacement between the original and the best-correlated position defines a local displacement vector. Repeating this process at multiple regions across the image generates a discrete vector field.

The resulting discrete vector field may then be fitted using a low-order polynomial surface (e.g., a two-dimensional third-order polynomial or another suitable model) to interpolate displacement values across the image. This interpolation provides continuous displacement estimates at each pixel or on a finer grid, enabling sub-pixel resolution in the final distortion map.

These displacement vectors may be used to define a pixel-wise backward mapping, where each output pixel location in the corrected image is mapped to a displaced location in the original distorted image. Because the mapped coordinates may fall between pixel centers, interpolation (e.g., bilinear or bicubic) may be performed to resample pixel intensities. This correction process is applied to each image in the plurality to generate a corresponding plurality of distortion corrected images. The plurality of distortion corrected images may then be averaged to produce a composite distortion corrected image with reduced noise and improved spatial fidelity.

The method described by flowchart 600 provides for a method of image distortion correction for images generated by a charged particle beam apparatus. The method enables image distortion correction for noisy or low-contrast images, eliminating the need for contour feature extraction. Interpolation of the distortion map allows pixel-by-pixel correction across the FOV. The method may be suited for high-throughput workflows, for example in a lithographic process that checks for errors or fidelity of a pattern.

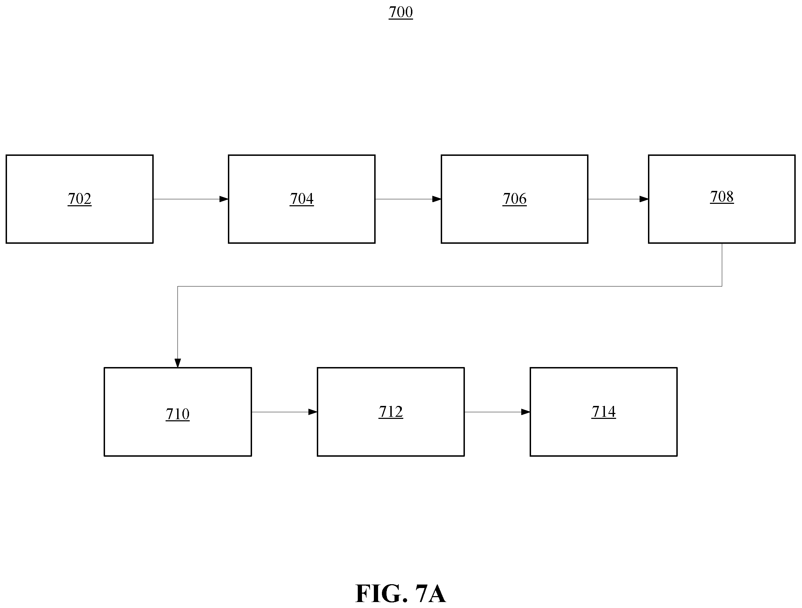

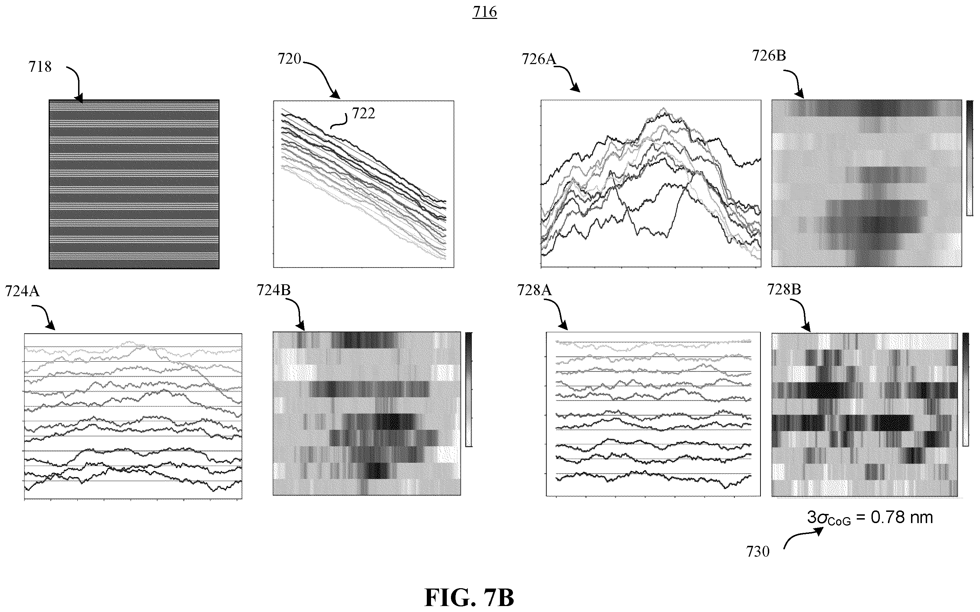

While the method described in flowchart 600 enables distortion correction using spatial cross-correlation within a single field of view, alternative approaches may leverage comparisons across multiple wafer locations to identify repeatable, site-independent distortion effects. Such systematic distortions-often originate from the reticle or imaging system-may not be observable through frame-to-frame analysis alone. These repeatable patterns can be addressed using the method described in flowchart 700. Reference is now made to **FIG. 7****.**

**FIG. 7A** illustrates an exemplary flowchart 700 describing a method of image distortion correction for removing systematic distortion fingerprints, consistent with embodiments of the present disclosure. The method according to flowchart 700 may be applied to correct images generated by a charged particle beam apparatus, such as the inspection tool of **FIG. 1** or the single-beam or multi-beam apparatuses of **FIGS. 2A** and **2B****.** Unlike prior methods (e.g., those described in FIGS. 4-6) that determine distortions by repeatedly imaging the same substrate location over time, the method of **FIG. 7A** analyzes images acquired from separate locations on a substrate containing the same nominal target design. This enables identification of systematic distortion fingerprint effects that are consistent across locations, such as those introduced by the reticle, lens field, or beam deflection system.

**FIG. 7B** illustrates an example implementation 716 of the method of flowchart 700. Implementation 716 represents an approach to systematic distortion fingerprint determination and removal based on center of gravity (CoG) analysis rather than full position data. The CoG data may represent a numerical indication of the average position of features within a field of view (FOV) and may be used to detect, quantify, and remove image distortions across images acquired by a charged particle beam apparatus.

At operation 702, a plurality of images from separate locations on a substrate may be acquired with a charged particle beam apparatus. In some embodiments, each image in the plurality of images may be acquired from a different location on a wafer. The images may also have distortion-corrected applied to them in the manner described by flowchart 400 in **FIG. 4****,** flowchart 500 in **FIG. 5****,** or flowchart 600 in **FIG. 6****.** Each image may scan the same nominal design, which may allow for isolation of systematic distortion effects from structural variations. The field of view (FOV) of each image may comprise identical or equivalent features.

For example, with reference to **FIG. 7B** **,** when performing operation 702, an image 718 may be acquired of a nominal design at different locations on a wafer. The field of view (FOV) of the image may contain periodic structures (e.g., grating lines or marks) disposed on a substrate with the same nominal design.

At operation 704, the plurality of images may be processed to generate position data. For example, a contouring algorithm may be applied to each image in the plurality of images to extract feature position maps (e.g., position data). The contouring algorithm may convert greyscale image intensity to position maps, generating a corresponding plurality of position maps that define the spatial coordinates of features (e.g., in position x and y). In some embodiments, optionally, the plurality of images may be corrected using the methods described in flowchart 400 described above in reference to **FIG. 4** to remove dynamic distortions. In some embodiments, optionally, the plurality of images may be corrected using the methods described in flowchart 500 described above in reference to **FIG. 5** to remove dynamic distortions.

At operation 704, with reference to **FIG. 7B****,** feature positions may be extracted from the image 718 using a CoG-based method. As shown in plot 720, the CoG of each feature may be plotted modulo the expected mark pitch. Plot 720 shows CoG (pixels) as a function of a position along the feature (pixel). Plotted modulo the expected mark pitch may refer to each CoG position being normalized to fall within a single pitch interval. For example, if the mark pitch is 100nm, a feature located at 250 nm may be plotted at 50 nm (e.g., 250 mod 100). The normalization collapses feature positions onto a single unit cell layout of the perioding structure. This may allow for identification of the systematic distortion fingerprint that repeats across marks.

A three-parameter (3-par) model 722 may then be fitted to the normalized CoG data to remove global distortion components, for example those components occurring due to translation, magnification, rotation etc. An example 3-par model may be expressed as: $ΔCoG \left(x, y\right) = a + b ⋅ x + c ⋅ y .$ where a, b, and c are scalar coefficients representing a constant offset (e.g., translation), a magnification term along the x-axis, and a rotation term along the y-axis. The model may serve to isolate low-order distortion across the FOV prior to systematic distortion fingerprint removal. Use of a higher order model may eliminate mark-related variations.

At operation 706, distortion correction may be applied to the position data using a low-parametric model (e.g., three parameters) to correct for global image distortions such as magnification or rotation. This yields a plurality of corrected position maps. For example, each position map in the plurality of position maps (e.g., position data), the residual positional errors (e.g., deviations remaining after parametric correction) may be computed. These residuals may be interpreted as spatial displacement vectors forming a distortion map for each image, also referred to as distortion data.

With reference to **FIG. 7B****,** at operation 706, the fitted 3-par model referenced above may be subtracted from the CoG traces described in plot 720, yielding residual data. Residual traces after the model subtraction are defined in plot 724A. The residuals position map is shown in position map 724B. The residuals demonstrate positional variations not captured by the 3-par model in operation 704, which may include systematic effects or higher order spatial trends.

At operation 708, a systematic distortion fingerprint may be determined by averaging the distortion data (residual-based distortion maps) across all locations to produce averaged distortion data. The averaging procedure identifies spatially repeatable distortion patterns present across the plurality of substrate locations. These repeatable displacement vectors constitute the systematic distortion fingerprint. The resulting averaged distortion data represents the characteristic distortion pattern (e.g., due to reticle asymmetry or beam path non-uniformity) across the substrate.

With reference to **FIG. 7B****,** at operation 708, residual data from a large plurality of images may be collected (e.g., from 100 images). Residual traces may be shown from multiple locations in plot 726A. The average of the residual traces in plot 726A may be computed to determine the systematic distortion fingerprint. The resulting position map 726B defines systematic distortion fingerprints describing repeatable distortions across substrate locations, such as those introduced by reticle patterning or tool asymmetry.

At operation 710, the effectiveness of fingerprint averaging may be assessed. It may be determined that the averaging removes the systematic distortion fingerprint. In some embodiments, the removal of the systematic distortion fingerprint may be accepted, and analysis may proceed. In some embodiments, further averaging may be performed. The systematic distortion fingerprint may be determined as an average over multiple designs and features. This may reduce sensitivity to the design that was used for the original plurality of images to determine the systematic distortion fingerprint. In some embodiments, the features under study may be rotated and images of multiple rotational orientations may be acquired. For example, the substrate may be rotated between acquisitions.

At operation 712, the systematic distortion fingerprint may be removed from either the position data or the plurality of images. The correction may be applied to the position data. This may be performed by subtracting the systematic distortion fingerprint (e.g., the displacement vectors corresponding to residuals) from each position data map in the position data to provide distortion corrected position data. The distortion corrected position data may then be averaged to provide a composite distortion corrected position data.

The systematic distortion fingerprint may be removed from the plurality of images. To do this, the systematic distortion fingerprint may first be interpolated on a pixel-by-pixel basis across the field of view to generate continuous distortion map (e.g., distortion data), wherein each pixel is assigned a spatial displacement vector. For each image of the plurality of images, backward mapping may be applied: for each output pixel location, a corresponding location in the original distorted image may be determined by subtracting the interpolated displacement vector defined in the distortion map. This remapping may not fall on a pixel grid, and therefore interpolation is used to resample the image intensity at the computed location. This process is repeated for each image to generate a plurality of distortion corrected images. In some embodiments, the distortion corrected images may be averaged to yield a composite distortion corrected image with enhanced signal-to-noise ratio and improved spatial fidelity.

With reference to **FIG. 7B****,** at operation 712, the systematic distortion fingerprint may be subtracted from each individual images CoG data. The corrected CoG data are shown in plot 728A and the corresponding corrected position map 728B. A statistical summary 730 may be calculated, quantifying the 3σ variation of the corrected CoG across the image and FOV. In the example, the statistical summary 730, 3σ = 0.78 nm, demonstrating precision gained through systematic fingerprint removal.

At operation 714, either the plurality of distortion corrected position data or plurality of distortion corrected images may be used for further analysis (e.g., CD metrology, defect inspection, etc.). In some embodiments, the composite distortion corrected position data may be used for further analysis. In some embodiments, the composite distortion corrected image may be used for further analysis.

The example described **FIG. 7B** illustrates a simplified framework using CoG data, rather than full position maps, to effectively remove systematic distortion fingerprints across a wafer. CoG data may reduce computational complexity and reduce resources. CoG analysis enables efficient fitting and removal of low-order distortion trends across images while suppressing sensitivity to local noise or feature-specific variation. This approach allows rapid estimation of a systematic distortion fingerprints, particularly suitable for high-throughput or inline metrology workflows.

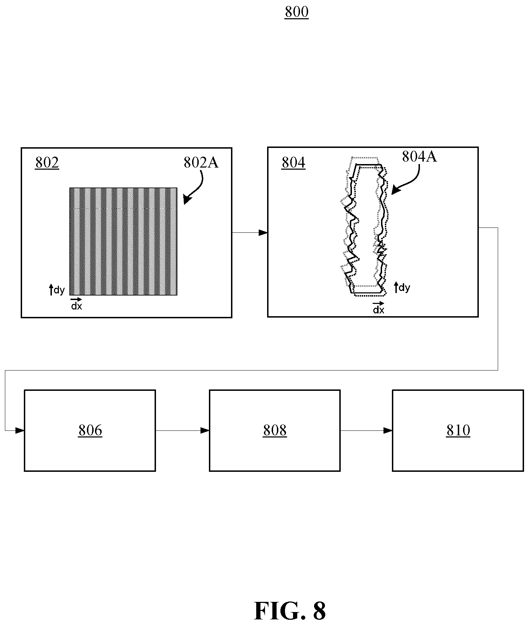

Following the removal of systematic distortion fingerprints as described with reference to FIGS. 7A and 7B, additional distortion correction may be required to address dynamic distortions that vary on shorter timescales and may impact image fidelity in different ways. While systematic distortions tend to be spatially repeatable and consistent across wafer locations, dynamic distortions may result from tool instability, stage drift, or beam fluctuations during image acquisition. These distortions can vary from image to image, even when scanning the same target design, and often manifest along specific feature orientations. For example, in images containing grating lines, dynamic distortions may appear as directional blur or feature displacement along the grating axis. Reference will now be made to **FIG. 8****.**

**FIG. 8** illustrates an exemplary schematic flowchart 800 for a method for detecting and correcting dynamic distortions of images comprising grating lines, consistent with embodiments of the present disclosure. In accordance with the embodiment, image distortions may be corrected along the direction of the grating line. Image distortion along the grating axis (e.g., y-direction) may cause image blur, spatial misalignment, and degraded accuracy in line-edge roughness (LER) and line-width roughness (LWR). The method described by flowchart 800 may be used to correct images generated by inspection tool described in reference to **FIG. 1****.** The method described in flowchart 800 may be used to correct images generated in a charged particle beam apparatus, for example the single-beam or multi-beam apparatus of either **FIG. 2A** or **FIG. 2B**

At operation 802, a plurality of images 802A may be acquired with a charged particle beam apparatus. The plurality of images 802A may comprise a FOV that may include periodic features disposed on a substrate, such as lines or bars oriented along a common axis, typically the y-direction. In image 802A, grating lines are oriented along the y-direction (dy), perpendicular to the edge variation direction (x).The plurality of images 802A may be acquired over aa short acquisition period. The plurality of images 802A may comprise frame-to-frame distortions caused by beam instability, drift, etc.

At operation 804, position data may be determined by extracting positions of the line edge along the y-direction (dy). A contouring algorithm may be applied to trace and extract the grating line edge from each image in the plurality of images 802A to output position map 804A. Optionally, the contouring algorithm may be applied to each image in the plurality of images 802A to provide a plurality of position maps. These position maps represent position data indicating the transverse (x) location of the edge as a function of position along the grating direction (y).The position map 804A defines both the intrinsic edge profile (e.g., line-edge roughness) and any distortion-induced displacement in the y direction.

At operation 806, a spatial relationship may be applied to position data to quantify relative offsets between frames along the y-direction. For example, a spatial cross-correlation may be applied to the plurality of positions maps. The cross-correlation may also be applied to subsets of the position maps, which may allow for capture of spatially varying distortions and not only global translations along the y-direction. The resulting offset vectors form a set of displacement vectors describing motion of the grating features between frames. These displacement vectors collectively form a distortion map, which may be referred to as distortion data describing grating-axis misalignments across the image series.

At operation 808, distortion correction may be applied using the determined distortion data. In some embodiments, the distortion correction may be applied to the plurality of position maps provided at operation 804. The distortion data may be subtracted from each position map (e.g., position data) to generate a plurality of distortion-corrected position maps (e.g., distortion corrected position data). This step may remove distortion-induced displacements from the extracted edge locations, enhancing their spatial accuracy.

In some embodiments, the distortion correction may be applied to the plurality of images 802A. In this case, the distortion data may be interpolated to generate a continuous pixel-wise distortion map (e.g., using bilinear or bicubic interpolation). For each output pixel in a corrected image, a corresponding location in the original distorted image is determined by backward mapping using the interpolated displacement vector. Resampling (e.g., via interpolation) is then applied to assign intensity values to the corrected image. This process is repeated for each image in the plurality of images to generate a plurality of distortion corrected images.

At operation 810, the plurality of distortion corrected images or the distortion corrected position data may be used for further analysis. In some embodiments, the plurality of distortion corrected images may be averaged to provide a composite distortion corrected image for noise reduction and improve spatial alignment. In some embodiments, the distortion corrected position data may be averaged to provide a composite distortion corrected position data for enhanced line-edge analysis. Averaging distortion-corrected images improves signal-to-noise ratio; while averaging corrected position data enhances precision in edge profile analysis.

The method described by flowchart 800 may be implemented using line-width roughness (LWR) instead of line-edge roughness. Line-width roughness may be defined as the distance between the opposing line edges, extracted as a function of position along a direction orthogonal to the line edges (e.g., the y-direction). A statistical metric, such as the standard deviation or a three-sigma (3σ) value, may be computed from the extracted line-width values to characterize variation in the line-width. LWR may be insensitive or much less sensitive to distortions in the x-direction. The insensitivity may provide robust signals for determining and correcting y-direction distortion only.

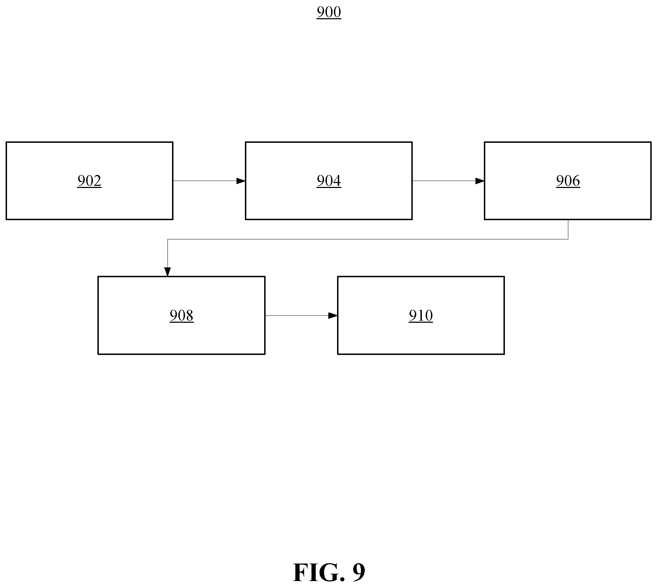

While the method described in flowchart 800 focuses on detecting and correcting image distortion along the grating axis to improve measurement fidelity, such corrections also enable more reliable downstream metrology analysis. More generally, the output of the methods described in flowcharts 400, 500, 600, 700, and 800, including distortion-corrected images and position data, can be used for downstream analyses. In particular, distortion-corrected images and position data can be used to extract accurate statistical metrics related to line-edge placement or width variation. These metrics, including line-edge roughness (LER) and line-width roughness (LWR), can serve as key performance indicators (KPIs) reflecting lithographic fidelity and process stability. Reference is now made to **FIG. 9****.**

**FIG. 9** illustrates an exemplary flowchart 900, consistent with embodiments of the present disclosure. Flowchart 900 may comprise a method for extracting statistical key performance indicators (KPI) from images acquired with a charged particle beam apparatus. The method according to flowchart 900 provides a framework for quantifying low frequency spatial placement variability (e.g., intramark variation) caused by line-edge roughness (LER) and translating to KPIs for process monitoring or alignment mark optimization.

At operation 902, images may be acquired across a fixed field of view (FOV) comprising periodic gratings or other patterned structures produced by a lithographic process. In some embodiments, the acquisition may comprise a plurality of images. Dynamic distortion correction may be applied in accordance with any of or a combination of methods described in reference to flowchart 400 **(****FIG. 4****),** flowchart 500 **(****FIG. 5****),** flowchart 600 **(****FIG. 6****),** flowchart 700 **(****FIG. 7A****),** or flowchart 800 **(****FIG. 8****).**

At operation 904, one or more image distortion correction methods (or a combination thereof) may be applied to the acquired plurality of images at operation 902. In some embodiments, distortion correction may be performed according to methods described in reference to flowchart 400 **(****FIG. 4****),** flowchart 500 **(****FIG. 5****),** flowchart 600 **(****FIG. 6****),** flowchart 700 **(****FIG. 7A****),** or flowchart 800 **(****FIG. 8****).** One or more corrections may be applied or a combination of methods may be applied. A plurality of distortion corrected images may be provided by application of the image distortion correction methods.

At operation 906, the plurality of distortion corrected images may be processed to generate position data, such as position maps describing extracted feature locations .In an example, a contouring algorithm may be applied to the plurality of distortion corrected images to extract positions of features and provide a plurality of position maps. The resulting plurality of position maps may provide spatial positions of features on a pixel-by-pixel basis after removal of image distortions.

At operation 908 statistical analysis is performed on the position data (e.g., position maps) to determine one or more key performance indicators (KPIs). In some embodiments, a feature data profile may be constructed by aggregating feature positions across the FOV. A feature data profile refers to any dataset that characterizes spatial variation of extracted features, including but not limited to edge position, width, centroid, or intensity distribution. A standard variance (for example 3σ as in the example described in **FIG. 7B****)** may be computed from the position data to estimate the spread of edge positions. Alternatively, a power spectral density (PSD) spectrum may be calculated, allowing for isolation of long-wavelength (e.g., low frequency) variations across the FOV. Image distortion correction as applied by the methods (or a combination thereof) described in reference to flowchart 400 **(****FIG. 4****),** flowchart 500 **(****FIG. 5****),** flowchart 600 **(****FIG. 6****),** flowchart 700 **(****FIG. 7A****),** or flowchart 800 **(****FIG. 8****)** remove artificial contributions. KPIs can more effectively reflect pattern fidelity. The removal of image distortion ensures that these KPIs reflect true pattern variability, not imaging artifacts.

At operation 910, the extracted KPIs may be used for further analysis. For example, monitoring intramark variations, assessing process stability, or optimizing alignment mark design. For example, the PSD may be used at long wavelengths to evaluate the efficacy of a lithographic process in preserving low-frequency placement accuracy.

The method according to flowchart 900 enables accurate measurements of statistical placement metrics over long spatial scales. The method leverages the image distortion correction methods as outlined in reference to flowchart 400 **(****FIG. 4****),** flowchart 500 **(****FIG. 5****),** flowchart 600 **(****FIG. 6****),** flowchart 700 **(****FIG. 7A****),** or flowchart 800 **(****FIG. 8****).** The leverage may reflect accurate pattern quality and variations, rather than artificial image distortions.

A non-transitory computer-readable medium may be provided that stores instructions for a processor of a controller (e.g., controller 109 in **FIG. 1****)** for determining dynamic distortions and correcting them according to the exemplary flowcharts of **FIG 4-9** above], consistent with embodiments in the present disclosure. For example, the instructions stored in the non-transitory computer-readable medium may be executed by the circuitry of the controller for performing method according to flowchart 400, 500, 600, 700, 800, or 900, in part or entirely. Common forms of non-transitory media include, for example, a floppy disk, a flexible disk, hard disk, solid-state drive, magnetic tape, or any other magnetic data storage medium, a Compact Disc Read-Only Memory (CD-ROM), any other optical data storage medium, any physical medium with patterns of holes, a Random Access Memory (RAM), a Programmable Read-Only Memory (PROM), and Erasable Programmable Read-Only Memory (EPROM), a FLASH-EPROM or any other flash memory, Non-Volatile Random Access Memory (NVRAM), a cache, a register, any other memory chip or cartridge, and networked versions of the same.

Some embodiments may further be described using the following clauses:
1. A method of reducing distortion of images acquired from a charged-particle beam apparatus, the method comprising:
   acquiring, with the charged-particle beam apparatus, a plurality of images over an acquisition period of a fixed field of view, the plurality of images comprising features disposed on a substrate;
   processing the plurality of images to generate a corresponding position data for each image, wherein the position data corresponds to the features in each image;
   extracting first positional information of the features from the position data for each image,
   determining temporal variations in the first positional information of the features over the acquisition period;
   extrapolating the temporal variations towards a reference time to generate second positional information;
   determining image distortion based on a comparison between the second positional information and the first positional information; and
   applying an update to the plurality of images based on the determined image distortion.
2. The method of clause 1, wherein the second positional information at the reference time represents an image absent of image distortion.
3. The method of any one of the clauses 1-2, wherein the second positional information is generated by extrapolating the first positional information toward the reference time.
4. The method of any one of the clauses 1-3, further comprising determining distortion data by comparing the position data to the second positional information, wherein the distortion data comprises spatial displacement vectors that describe relative positional offsets of the first positional information with respect to the second positional information.
5. The method of clause 1, wherein applying the update to the position data comprises:
   aligning the first positional information using the distortion data; and
   generating updated position data by shifting the first positional information toward a corresponding position defined in the second positional information.
6. The method claim any one of the clauses 1-5 further comprising averaging the updated position data to generate a composite updated position data.
7. The method of any one of the clauses 1-6, wherein applying the update to the plurality of images comprises:
   aligning a pixel grid of each image in the plurality of images using corresponding distortion data;
   shifting each pixel position based on a backward mapping from the second positional information by subtracting the distortion data; and
   resampling each image at the shifted pixel positions using sub-pixel interpolation to generate a plurality of updated images.
8. The method of clause 7 further comprising averaging the plurality of updated images to generate a composite updated image.
9. The method of any one of the clauses 1-8, wherein prior to processing the plurality of images to generate position data, the method comprises:
   defining groups of pixels within each image in the plurality of images; and
   averaging the groups of pixels to generate a plurality of group averaged line traces.
10. The method of any one of the clauses 1-9, wherein averaging the groups of pixels comprises:
   averaging individual line traces within each group of pixels to generate a group-averaged line trace for each group; and
   averaging the group-averaged line traces across the groups of pixels to generate a plurality of group-averaged line traces corresponding to each image in the plurality of images.
11. The method of any one of the clauses 1-10, wherein processing the plurality of images to generate position data comprises:
   processing the plurality of group-averaged line traces to generate the position data.
12. The method of clause 10-11 further comprising performing an iterative process wherein the groups of pixels are redefined as larger groups of pixels if a contrast-to-noise ratio (CNR) threshold is not met, wherein the larger groups of pixels enable improved spatial resolution while maintaining signal-to-noise performance.
13. The method of any one of the clauses 1-12, wherein subsets of the updated position data are averaged separately.
14. The method of any one of the clauses 1-13, wherein subsets of the plurality of updated images are averaged separately.
15. A method of determining a systematic distortion fingerprint of a charged-particle beam apparatus, the method comprising:
   acquiring, with the charged-particle beam apparatus, a plurality of images over an acquisition time from different locations on a substrate, wherein each location comprises features having a same nominal design;
   processing the plurality of images to generate position data corresponding to the features; and
   averaging the processed position data from the different locations to provide a systematic distortion fingerprint.
16. A method of reducing distortion of images acquired from a charged-particle beam apparatus, the method comprising:
   acquiring, with the charged particle beam apparatus, a plurality of images of a field of view comprising periodic features aligned along a grating direction;
   processing the plurality of images to generate position data corresponding to edge positions of the periodic features;
   applying a spatial relationship to the positions data to determine distortion data comprising displacement vectors representing frame-to-frame displacements of edge positions along the grating direction; and
   applying an update to the plurality of images based on the determined image distortion.
17. The method of clause 16, wherein applying an update to the position data comprises:
   subtracting the distortion data from the position data to generate updated position data;
      and
   averaging the updated position data to provide composite updated position data.
18. The method of any one of the clauses 16-17, wherein applying an update to the plurality of images comprises:
   interpolating the distortion data to generate continuous pixel-wise distortion data;
   performing backward mapping to compute corrected pixel positions for each image based on the interpolated distortion data;
   resampling each image using interpolation at the corrected pixel positions to update the plurality of images; and
   averaging the updated images to generate a composite updated image.
19. The method of any one of the clauses 16-18 wherein the method further comprises determining line-width roughness by extracting line-width as a function of position along a direction orthogonal to the line edges and calculating a statistical metric that characterizes a variation in the line-width, wherein the line-width roughness corresponds to the statistical metric.
20. A method of reducing distortion of images acquired from a charged-particle beam apparatus, the method comprising:
   acquiring, with the charged-particle beam apparatus, a plurality of images over an acquisition time of a field of view comprising features disposed on a substrate, wherein
   each image comprises a pixel grid;
   defining groups of pixels within each image in the plurality of images;
   applying a spatial relationship between corresponding groups of pixels across the plurality of images to determine distortion data, wherein the distortion data comprises displacement vectors for the corresponding groups of pixels;
   extracting first positional information of features from the distortion data;
   determining temporal variations in the first positional information of the features over the acquisition time;
   extrapolating the temporal variations towards a reference time to generate second positional information;
   determining image distortion based on a comparison between the second positional information and the first positional information; and
   applying an update to the plurality of images based on the determined image distortion.
21. The method of clause 20, wherein the second positional information at the reference time represents an image absent of image distortion.
22. The method of any one of the clauses 20-21, wherein applying a spatial relationship comprises applying a spatial cross-correlation in two dimensions to determine offset vectors in both x- and y- directions.
23. The method of any one of the clauses 20-22, wherein applying an update to the plurality of images comprises:
   applying distortion data to shift the pixel grid by computing corrected pixel positions using the offset vectors;
   resampling the image at the corrected pixel positions using interpolation; and
   updating the plurality of images.
24. The method of any one of the clauses 20-23, further comprising averaging the plurality of updated images to generate a composite updated image.
25. A method of determining a key performance indicator (KPI) of a charged particle beam apparatus, the method comprising:
   acquiring, with a charged-particle beam apparatus, a plurality of images of features disposed on a
      substrate;
      applying an image distortion correction to update the plurality of images;
   processing the updated images to extract positional information and generate position data;
   determining a feature data profile of features from the position data; and
   deriving a statistical metric from the feature data profile as an indicator of operational performance of the charged particle beam apparatus.

It may be appreciated that the embodiments of the present disclosure are not limited to the exact construction that has been described above and illustrated in the accompanying drawings and that various modifications and changes may be made without departing from the scope thereof.

## Claims

1. A method of reducing distortion of images acquired from a charged-particle beam apparatus, the method comprising:
acquiring, with the charged-particle beam apparatus, a plurality of images over an acquisition period of a fixed field of view, the plurality of images comprising features disposed on a substrate;
processing the plurality of images to generate a corresponding position data for each image, wherein the position data corresponds to the features in each image;
extracting first positional information of the features from the position data for each image,
determining temporal variations in the first positional information of the features over the acquisition period;
extrapolating the temporal variations towards a reference time to generate second positional information;
determining image distortion based on a comparison between the second positional information and the first positional information; and
applying an update to the plurality of images based on the determined image distortion.

2. The method of claim 1, wherein the second positional information at the reference time represents an image absent of image distortion.

3. The method of claim 1, wherein the second positional information is generated by extrapolating the first positional information toward the reference time.

4. The method of claim 1, further comprising determining distortion data by comparing the position data to the second positional information, wherein the distortion data comprises spatial displacement vectors that describe relative positional offsets of the first positional information with respect to the second positional information.

5. The method of claim 4, wherein applying the update to the position data comprises:
aligning the first positional information using the distortion data; and
generating updated position data by shifting the first positional information toward a corresponding position defined in the second positional information.

6. The method claim 5, further comprising averaging the updated position data to generate a composite updated position data.

7. The method of claim 4, wherein applying the update to the plurality of images comprises:
aligning a pixel grid of each image in the plurality of images using corresponding distortion data;
shifting each pixel position based on a backward mapping from the second positional information by subtracting the distortion data; and
resampling each image at the shifted pixel positions using sub-pixel interpolation to generate a plurality of updated images.

8. The method of claim 7, further comprising averaging the plurality of updated images to generate a composite updated image.

9. The method of claim 1, wherein prior to processing the plurality of images to generate position data, the method comprises:
defining groups of pixels within each image in the plurality of images; and
averaging the groups of pixels to generate a plurality of group averaged line traces.

10. The method of claim 9, wherein averaging the groups of pixels comprises:
averaging individual line traces within each group of pixels to generate a group-averaged line trace for each group; and
averaging the group-averaged line traces across the groups of pixels to generate a plurality of group-averaged line traces corresponding to each image in the plurality of images.

11. The method of claim 10, wherein processing the plurality of images to generate position data comprises:
processing the plurality of group-averaged line traces to generate the position data.

12. The method of claim 10, further comprising performing an iterative process wherein the groups of pixels are redefined as larger groups of pixels if a contrast-to-noise ratio (CNR) threshold is not met, wherein the larger groups of pixels enable improved spatial resolution while maintaining signal-to-noise performance.

13. The method of claim 10, wherein subsets of the updated position data are averaged separately.

14. The method of claim 10, wherein subsets of the plurality of updated images are averaged separately.

15. A method of determining a systematic distortion fingerprint of a charged-particle beam apparatus, the method comprising:
acquiring, with the charged-particle beam apparatus, a plurality of images over an acquisition time from different locations on a substrate, wherein each location comprises features having a same nominal design;
processing the plurality of images to generate position data corresponding to the features; and
averaging the generated position data from the different locations to provide a systematic distortion fingerprint.
